# EUROPEAN PATENT APPLICATION

(11) **EP 4 593 556 A1**
(43) Date of publication of application: **30.07.2025**
(21) Application number: 25150202.7
(22) Date of filing: 03.01.2025
(51) Int. Cl.: H10F 10/142, H10F 19/31, H10F 19/35, H10F 19/75

(54) **MONOLITHIC PHOTOVOLTAIC SOLAR PANEL WITH MICRO-PV CELLS AND INTEGRATED, MONOLITHIC BYPASS DIODES**

(30) Priority: 23.01.2024 US 202418420339
(71) Applicant: The Boeing Company, Arlington, VA 22202 (US)
(72) Inventor: Rehder, Eric, Arlington, 22202 (US)
(74) Representative: Witte, Weller & Partner Patentanwälte mbB

(57) **Abstract**

A photovoltaic (PV) solar panel, made of many micro-PV cells, where each micro-PV cell has its own integrated, monolithic bypass diode. Each micro-PV cell is a multi-junction solar cell that is approximately 1 cm on a side. An array of approximately fifty micro-PV cells, all connected in series, makes up a single "PV device", which generates 90-100 V at a low current. A PV solar panel includes multiple strings of these PV devices, connected in parallel, which generates a high photocurrent at 90-100 V. The multi-junction micro-PV cells can be made of stacked layers of Ge, GaAs, and InGaP PN.

## Description

### INTRODUCTION

This disclosure relates to multi-junction, photovoltaic (PV) micro-PV cell arrays with integrated monolithic bypass diodes used for PV solar panels. In particular, the disclosure relates to multi-junction PV solar cells for use in PV solar panels for satellites and spacecraft.

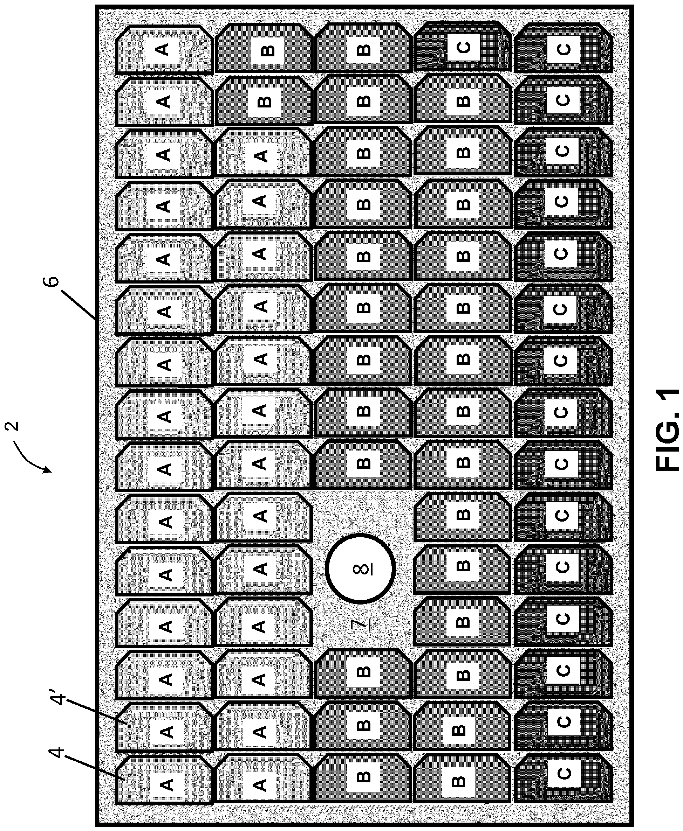

FIG. 1 illustrates schematically a plan view of an example of a PV solar panel 2 using large PV solar cells 4, 4', etc. mounted on a substrate 6. Each PV solar cell 4, 4', etc. is roughly one-half of a 150 mm round wafer and near 75 cm² in area. Larger cells pose challenges for high photocurrents and Electro Static Discharge (ESD), as well as finding useful layouts on a given panel. This example shows a layout of 15 x 5 solar cell locations, with 3 cells removed for the *"stayout zone"* 7 (which comprises a tubular structural member 8). The panel can fit a total of 72 solar cells. The output voltage of the system and the mission details may require 20-60 solar cells in series. Here, an example is sketched with 28 cells in series to form a circuit with a voltage of approximately 56 V (at 2 Volts per cell). The configuration of 72 cells is split into three circuits (identified by three different shadings). There are two circuits of 28 cells (circuits **A** and **B**) and one circuit of 16 cells (circuit **C**). The 16 cells of circuit **C** only generate about one-half (i.e., 32 V) of the required voltage. Hence, the cells of Circuit **C** would not contribute any power to the system and, therefore, would be removed from panel 2. Complicated arrangements could be designed combining partial circuits across multiple panels. That can help somewhat, but even then it would be best to have a 14 cell string and 2 cells would be left off the panel. This shows that fully utilizing solar power from a full area of a space PV solar panel can be challenging. The challenge is that the PV solar panel is composed of circuits requiring numerous solar cells. Each circuit requires a certain area. The panel's area is set by other constraints. It is likely that the circuits cannot fully fill the area of a solar panel, which reduces the potential power output.

### SUMMARY

In an example, a micro-PV cell includes: a right-side and a left-side; a first layer comprising a first semiconductor material; a second layer disposed on the first layer; a multi-junction micro-PV cell stack disposed on a portion of the second layer; a first trench extending down into the first layer, disposed on a left-side of the micro-PV cell; a second trench extending down into the first layer, and disposed on the right-side of the micro-PV cell; a third trench, disposed adjacent to the second trench and extending down into the second layer, wherein the third trench is disposed on the right-side of the micro-PV cell adjacent to a left-side of the second trench; a left-side first shoulder disposed on the left-side of the micro-PV cell at a bottom of the first trench; a right-side second shoulder disposed on the right-side of the micro-PV cell at a bottom of the second trench; a right-side third shoulder disposed on the right-side of the micro-PV cell at a bottom of the third trench; and an integrated monolithic bypass diode comprising the second layer disposed on the first layer. In another example, a photovoltaic (PV) micro-PV cell includes: a left-side and a right-side; a first layer comprising a first semiconductor material; a second layer comprising the first semiconductor material, disposed on the first layer; a third layer comprising the first semiconductor material, disposed on the second layer; a fourth layer comprising the first semiconductor material, and disposed on the third layer; and a fifth layer comprising a second semiconductor material that is disposed on the fourth layer; a sixth layer comprising the second semiconductor material that is disposed on the fifth layer; a seventh layer comprising a third semiconductor material that is disposed on the sixth layer; an eighth layer comprising a third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising the fourth layer disposed on the third layer.

In a further example, a PV device includes a string of three, identical micro-PV cells that are connected in series, which includes: a first micro-PV cell disposed on a common substrate; a second micro-PV cell disposed on the common substrate and electrically connected in series to the first micro-PV cell; and a third micro-PV cell disposed on the common substrate and electrically connected in series to the second micro-PV cell; wherein each one of the first, second, and third micro-PV cells comprises: a right-side and a left-side; a first layer comprising a first semiconductor material; a second layer disposed on the first layer; a multi-junction micro-PV cell stack disposed on a portion of the second layer; a first trench extending down into the first layer, disposed on a left-side of the micro-PV cell; a second trench extending down into the first layer, and disposed on the right-side of the micro-PV cell; a third trench, disposed adjacent to the second trench and extending down into the second layer, wherein the third trench is disposed on the right-side of the micro-PV cell adjacent to a left-side of the second trench; a left-side first shoulder disposed on the left-side of the micro-PV cell at a bottom of the first trench; a right-side second shoulder disposed on the right-side of the micro-PV cell at a bottom of the second trench; a right-side third shoulder disposed on the right-side of the micro-PV cell at a bottom of the third trench; and an integrated monolithic bypass diode comprising a buried PN junction disposed in between the second layer and the first layer; wherein the first micro-PV cell comprises a first top surface; wherein the second micro-PV cell comprises a second top surface; wherein the third micro-PV cell comprises a third top surface; and a first conductor electrically connecting the first layer to the first top surface of the first micro-PV cell; a second conductor electrically connecting the right-side third shoulder of the first micro-PV cell to the second top surface of the second micro-PV cell; and a third conductor electrically connecting the right-side third shoulder of the second micro-PV cell to the third top surface of the third micro-PV cell; wherein the common substrate is the first layer.

In another example, a PV device includes a string of three, identical micro-PV cells that are connected in series, including: a first micro-PV cell disposed on a common substrate; a second micro-PV cell disposed on the common substrate and electrically connected in series to the first micro-PV cell; and a third micro-PV cell disposed on the common substrate and electrically connected in series to the second micro-PV cell; wherein each one of the first, second, and third micro-PV cells comprises: a left-side and a right-side; a first layer comprising a first semiconductor material; a second layer comprising the first semiconductor material, disposed on the first layer; a third layer comprising the first semiconductor material, disposed on the second layer; a fourth layer comprising the first semiconductor material, and disposed on the third layer; a fifth layer comprising a second semiconductor material that is disposed on the fourth layer; a sixth layer comprising the second semiconductor material that is disposed on the fifth layer; a seventh layer comprising a third semiconductor material that is disposed on the sixth layer; an eighth layer comprising a third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising a buried PN junction disposed in between the fourth layer and the third layer; wherein the first micro-PV cell comprises a first top surface; wherein the second micro-PV cell comprises a second top surface; wherein the third micro-PV cell comprises a third top surface; a first conductor electrically connecting the first layer to the first top surface of the first micro-PV cell; a second conductor electrically connecting the right-side second shoulder of the first micro-PV cell to the second top surface of the second micro-PV cell; a third conductor electrically connecting the right-side second shoulder of the second micro-PV cell to the third top surface of the third micro-PV cell; a fourth conductor electrically connecting the right-side second shoulder of the first micro-PV cell to the first left-side shoulder of the second micro-PV cell; a fifth conductor electrically connecting the right-side second shoulder of the second micro-PV cell to the first left-side shoulder of the third micro-PV cell; wherein the integrated monolithic bypass diode of each micro-PV cell comprises a PN junction disposed in-between the fourth layer and the third layer of each micro-PV cell; and wherein the common substrate is the first layer.

In another example, a PV device includes an array of multiple micro-PV cells disposed on a common substrate and electrically connected in series; wherein each micro-PV cell comprises: a right-side and a left-side; a first layer comprising a first semiconductor material; a second layer disposed on the first layer; a multi-junction micro-PV cell stack disposed on a portion of the second layer; a first trench extending down into the first layer, disposed on a left-side of the micro-PV cell; a second trench extending down into the first layer, and disposed on the right-side of the micro-PV cell; a third trench, disposed adjacent to the second trench and extending down into the second layer, wherein the third trench is disposed on the right-side of the micro-PV cell adjacent to a left-side of the second trench; a left-side first shoulder disposed on the left-side of the micro-PV cell at a bottom of the first trench; a right-side second shoulder disposed on the right-side of the micro-PV cell at a bottom of the second trench; a right-side third shoulder disposed on the right-side of the micro-PV cell at a bottom of the third trench; and an integrated monolithic bypass diode comprising the second layer disposed on the first layer; wherein the common substrate is the first layer.

In another example, a PV device includes an array of multiple micro-PV cells disposed on a common substrate and electrically connected in series; wherein each micro-PV cell comprises: a left-side and a right-side; a first layer comprising a first semiconductor material; a second layer comprising the first semiconductor material, disposed on the first layer; a third layer comprising the first semiconductor material, disposed on the second layer; a fourth layer comprising the first semiconductor material, and disposed on the third layer; and a fifth layer comprising a second semiconductor material that is disposed on the fourth layer; a sixth layer comprising the second semiconductor material that is disposed on the fifth layer; a seventh layer comprising a third semiconductor material that is disposed on the sixth layer; an eighth layer comprising a third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising the fourth layer disposed on the third layer; wherein the common substrate is the first layer.

In another example, a PV solar panel includes an array of multiple PV devices, wherein each PV device includes an array of multiple micro-PV cells disposed on a common substrate and electrically connected in series; wherein each micro-PV cell comprises: a right-side and a left-side; a first layer comprising a first semiconductor material; a second layer disposed on the first layer; a multi-junction micro-PV cell stack disposed on a portion of the second layer; a first trench extending down into the first layer, disposed on a left-side of the micro-PV cell; a second trench extending down into the first layer, and disposed on the right-side of the micro-PV cell; a third trench, disposed adjacent to the second trench and extending down into the second layer, wherein the third trench is disposed on the right-side of the micro-PV cell adjacent to a left-side of the second trench; a left-side first shoulder disposed on the left-side of the micro-PV cell at a bottom of the first trench; a right-side second shoulder disposed on the right-side of the micro-PV cell at a bottom of the second trench; a right-side third shoulder disposed on the right-side of the micro-PV cell at a bottom of the third trench; and an integrated monolithic bypass diode comprising the second layer disposed on the first layer; wherein the common substrate is the first layer.

In another example, a PV solar panel includes an array of multiple PV devices, wherein each PV device includes an array of multiple micro-PV cells disposed on a common substrate and electrically connected in series; wherein each micro-PV cell comprises: a left-side and a right-side; a first layer comprising a first semiconductor material; a second layer comprising the first semiconductor material, disposed on the first layer; a third layer comprising the first semiconductor material, disposed on the second layer; a fourth layer comprising the first semiconductor material, and disposed on the third layer; a fifth layer comprising a second semiconductor material that is disposed on the fourth layer; a sixth layer comprising the second semiconductor material that is disposed on the fifth layer; a seventh layer comprising a third semiconductor material that is disposed on the sixth layer; an eighth layer comprising a third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising the fourth layer disposed on the third layer; wherein the common substrate is the first layer.

### BRIEF DESCRIPTION OF THE DRAWINGS

FIG. 1 shows a schematic plan view of an example of a PV solar panel.
FIG. 2A shows a schematic plan view of an example of a PV solar panel, according to the present disclosure.
FIG. 2B shows a schematic plan view of an example of underlying electrical interconnects of the PV solar panel of FIG. 2A, according to the present disclosure.
FIG. 3 shows a schematic cross-section side view of an example of the PV solar panel of FIG. 2A, according to the present disclosure.
FIG. 4A shows a schematic plan view of an example of a PV solar device, according to the present disclosure.
FIG. 4B shows a schematic plan view of an example of a PV solar device, illustrating 45 micro-PV solar cells connected in series of the device shown in FIG. 4A, according to the present disclosure.
FIG. 4C shows a schematic plan view of an example of a PV solar device, illustrating a continuous photocurrent path, ***I_{device},*** flowing through the forty-five micro-PV cells connected in series in a serial serpentine fashion, of the device shown in FIG. 4B, according to the present disclosure.
FIG. 5A shows a schematic plan view of an example of a pair of adjacent PV solar devices, according to the present disclosure.
FIG. 5B shows a schematic, close-up, plan view of an example of an electrical connection in between a pair of adjacent PV solar devices shown in FIG. 5A, according to the present disclosure.
FIG. 6A shows a schematic cross-section side view of an example of a single, multi-junction micro-PV cell with an integrated monolithic bypass diode, according to the present disclosure.
FIG. 6B shows a schematic cross-section side view of an example of a single, multi-junction micro-PV cell with an integrated monolithic bypass diode, according to the present disclosure.
FIG. 7A shows a schematic cross-section side view of an example of a PV solar cell device comprising three, multi-junction micro-PV cells with integrated monolithic bypass diodes, all connected in series, according to the present disclosure.
FIG. 7B shows a schematic cross-section side view of an example of a PV solar cell device comprising three, multi-junction micro-PV cells with integrated monolithic bypass diodes, all connected in series, according to the present disclosure.
FIG. 8A shows a schematic cross-section side view of an example of a single, multi-junction micro-PV cell with an integrated monolithic bypass diode, according to the present disclosure.
FIG. 8B shows a schematic cross-section side view of an example of a single, multi-junction micro-PV cell with an integrated monolithic bypass diode, according to the present disclosure.
FIG. 9A shows a schematic cross-section side view of an example of a PV solar cell device comprising three, multi-junction micro-PV cells with integrated monolithic bypass diodes, all connected in series, according to the present disclosure.
FIG. 9B shows a schematic cross-section side view of an example of a PV solar cell device comprising three, multi-junction micro-PV cells with integrated monolithic bypass diodes, all connected in series, according to the present disclosure.
FIG. 10A shows a schematic cross-section side view of an example of five, multi-junction micro-PV cells with integrated monolithic bypass diodes, all connected in series, according to the present disclosure.
FIG. 10B shows a schematic cross-section side view of an example of five, multi-junction micro-PV cells with integrated monolithic bypass diodes, all connected in series, with a single, shadowed micro-PV cell, according to the present disclosure.
FIG. 11 shows a schematic perspective view of an example of an extraterrestrial satellite with a pair of PV solar panels that are attached to satellite, wherein each PV solar panel comprises a plurality of multijunction PV solar devices with integrated monolithic bypass diodes (that are too small to be seen), according to the present disclosure.
FIG. 12 shows an example of a flow chart illustrating steps for fabricating a PV solar panel, according to the present disclosure.
FIG. 13A shows a schematic cross-section side view of an example of a single, multi-junction micro-PV cell with an integrated monolithic bypass diode, according to the present disclosure.
FIG. 13B shows a schematic cross-section side view of an example of a single, multi-junction micro-PV cell with an integrated monolithic bypass diode, according to the present disclosure.
FIG. 14A shows a schematic cross-section side view of an example of a PV solar cell device comprising three, multi-junction micro-PV cells with integrated monolithic bypass diodes, all connected in series, according to the present disclosure.
FIG. 14B shows a schematic cross-section side view of an example of a PV solar cell device comprising three, multi-junction micro-PV cells with integrated monolithic bypass diodes, all connected in series, according to the present disclosure.
FIG. 15A shows a schematic cross-section side view of an example of a single, multi-junction micro-PV cell with an integrated monolithic bypass diode, according to the present disclosure.
FIG. 15B shows a schematic cross-section side view of an example of a single, multi-junction micro-PV cell with an integrated monolithic bypass diode, according to the present disclosure.
FIG. 16A shows a schematic cross-section side view of an example of a PV solar cell device comprising three, multi-junction micro-PV cells with integrated monolithic bypass diodes, all connected in series, according to the present disclosure.
FIG. 16B shows a schematic cross-section side view of an example of a PV solar cell device comprising three, multi-junction micro-PV cells with integrated monolithic bypass diodes, all connected in series, according to the present disclosure.

### DETAILED DESCRIPTION

The words "PV solar cell", "solar cell", and "cell" are used interchangeably. The words "micro-PV cell" and "micro-cell" are used interchangeably. The words "PV solar device", "solar device", and "device" are used interchangeably. The words "first", "second", and so on refer to positional differences in structural elements. The words "right" and "right-side" are interchangeable, and "left" and "left-side" are interchangeable, and both refer to their respective positions as illustrated in the Drawings.

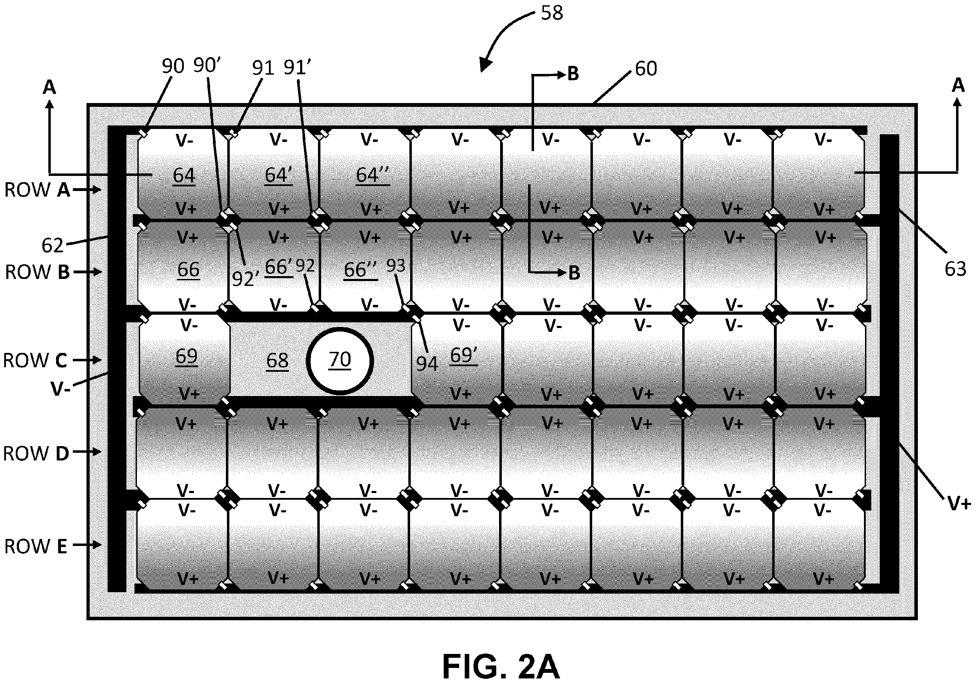

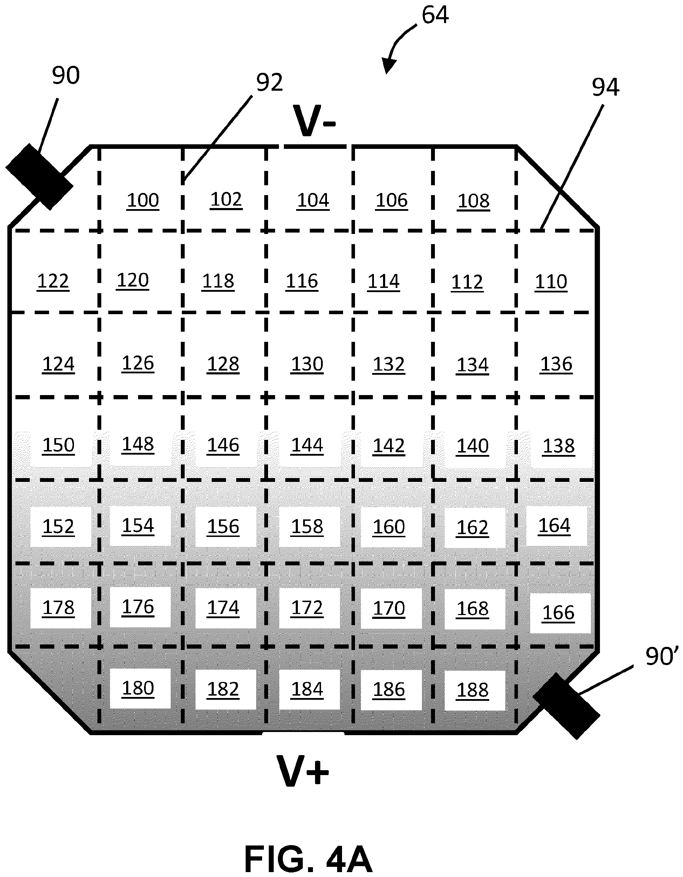

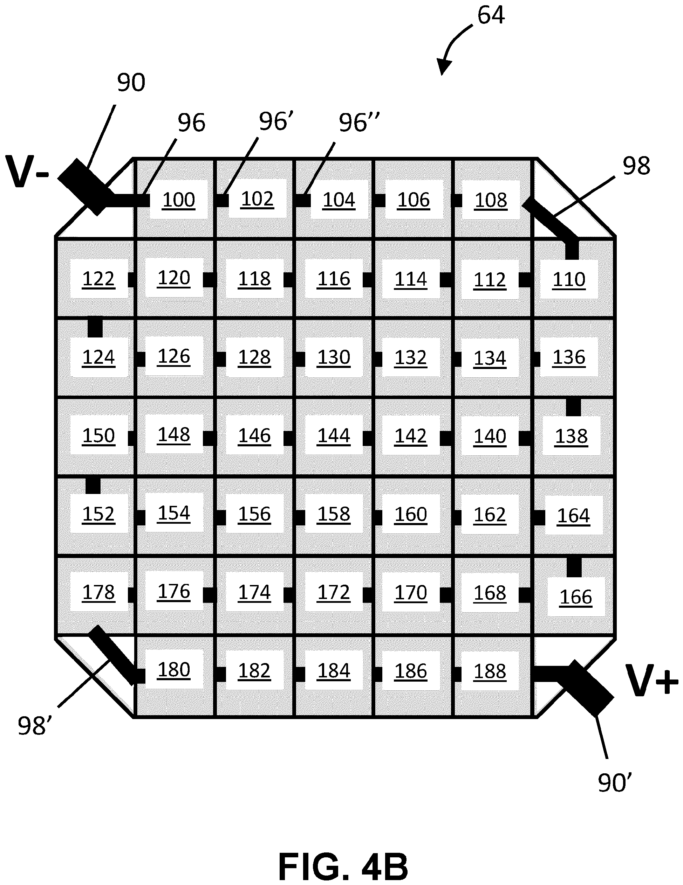

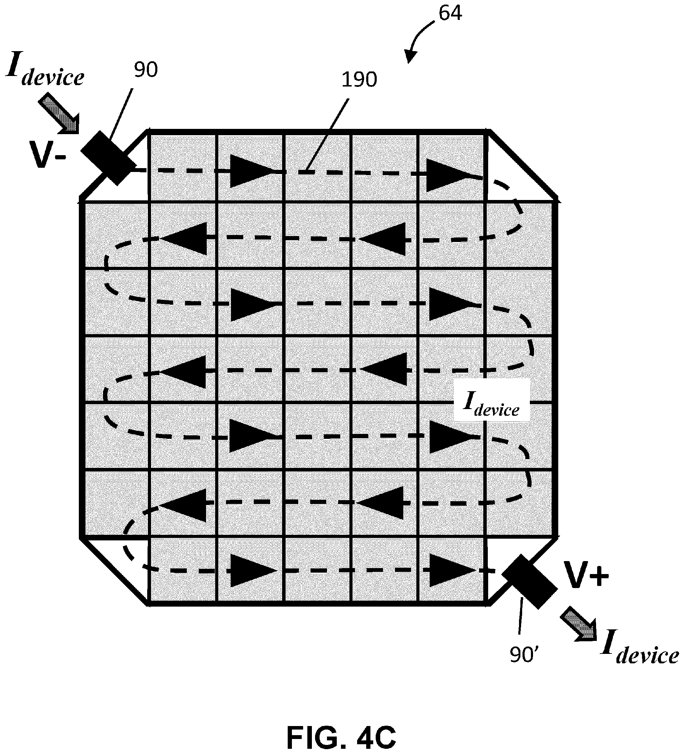

FIG. 2A shows a schematic plan view of an example of a PV solar panel 58, according to the present disclosure. PV solar panel 58 comprises a plurality of individual PV solar devices 64 , 64', 64", etc., arranged in a regular array across a substrate 60. The graded shading of each PV solar device 64, 64', 64", etc. indicates that there is a local voltage gradient that varies across each device 64, 64', 64", etc., from **V-** (in the lightly-shaded zone) to **V+** (in the darkly-shaded zone). In other words, the shading from light to dark follows the voltage gradient across an individual device (e.g., device 64). In this example, PV solar panel 58 comprises five parallel rows and eight columns of devices 64, 64', 64", etc., for a total of 38 PV solar devices (Note: two PV solar devices have been removed from the *"stayout zone"* 68, to make room for tubular structural member 70). Each individual PV solar device 64, 64', 64", etc., comprises an interconnected array of very small (e.g., 1 cm²), "micro" PV solar cells (e.g., 45 micro-PV cells, not shown in this figure), which are all connected in series to generate a high output voltage (e.g., 90 V) across every device 64, 64', 64", etc. In some examples, fabricated devices can have an area of about 150 cm². Details of a "device" will be described in greater depth in FIGS. 4A, 4B, and 4C. Each PV solar device 64, 64', 64", etc., comprises a pair of electrical connectors (voltage tabs) 90 and 90' located on opposite corners of device 64, and voltage tabs 91 and 91' located on opposite corners of device 64', and so on. Voltage tabs 90 and 91 negative voltages, and voltage tabs 90' and 91' conduct positive voltages, and so on. Each PV solar device 64, 64', 64", etc., is illustrated as having a square shape with cropped corners. Other shapes of PV solar device 64, 64', 64", etc. can be used, including rectangular shapes, triangular shapes, or hexagonal shapes, or combinations thereof).

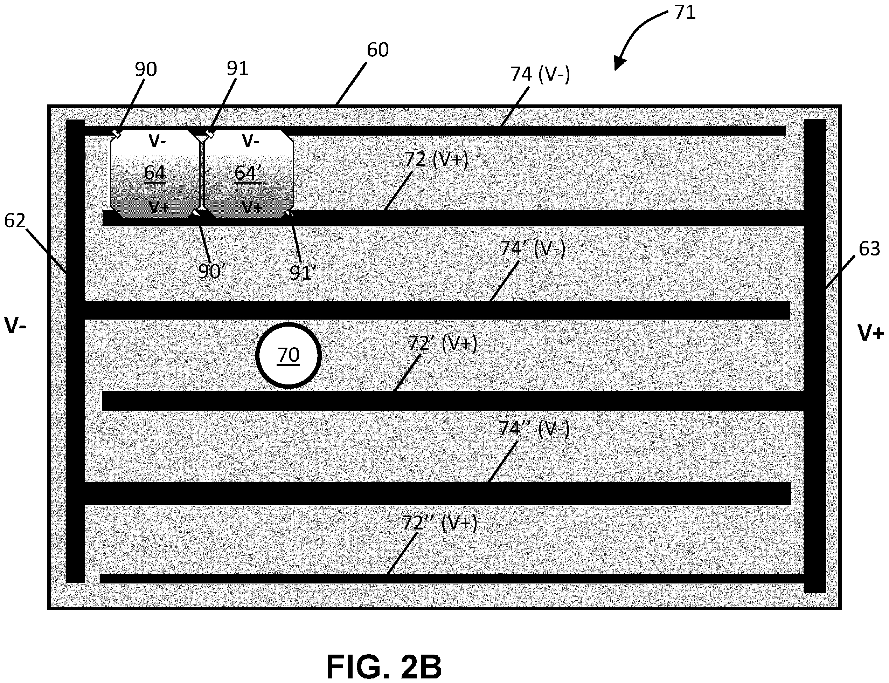

Referring still to FIG. 2A, the orientation of each row of 8 devices 64, 64', 64", etc. is reversed on alternating rows in this example. In other words, the devices 64, 64', 64", etc., are arranged so that **V-** regions of adjacent devices 66, 66', 66", etc., border each other, and **V+** regions of adjacent devices border each other. This alternating configuration minimizes problems with Electro Static Discharge (ESD). Disposed underneath the 40 PV solar devices is an interdigitated array of electrical interconnects (which are hidden from view by the PV solar devices 64, 64', 64", etc.) comprising negative and positive electrical buses 62 and 63, respectively (which is illustrated in greater detail on the following FIG. 2B). Negative electrical bus 62 has a voltage = **V-,** while positive electrical bus 63 has a voltage = **V+.** In this example, **V-** = 0 V and **V+** = 90 V. Each PV solar device 64, 64', 64", etc. produces a relatively higher voltage and a relatively lower photocurrent than traditional PV solar cells. Then each device is connected in parallel such that the overall solar panel produces a high voltage and high photocurrent. The positive voltage tabs 90' (**V+**) of each PV solar device 64, 64', 64", etc., are connected together across a given row of eight devices, and the negative voltage tabs 90 (**V-**) of each PV solar device 64, 64', 64", etc., are connected together across the same row of eight devices, so that the entire PV solar panel 58 generates a relatively high photocurrent at a high voltage (e.g., 90 V).

FIG. 2B shows a schematic plan view of an example of underlying electrical interconnect structure 71 of PV solar panel 58 of FIG. 2A, according to the present disclosure. Interconnect structure 71 comprises a pair of interdigitated electrical conductors, disposed on an insulated substrate 60, that are connected to a positive electrical bus 63 and to a negative electrical bus 62. Positive bus 63 comprises three parallel stripes 72, 72' and 72" connected to positive bus 63. Negative bus 62 comprises three parallel stripes 74, 74', 74" connected to negative bus 62, which are disposed in between (i.e., interdigitated between) the three positive parallel stripes 72, 72', and 72". A pair of PV solar devices 64 and 64' are illustrated. Negative voltage tabs 90 and 91 are electrically connected to negative stripe 74, and positive voltage tabs 90' and 91' are electrically connected to positive stripe 72.

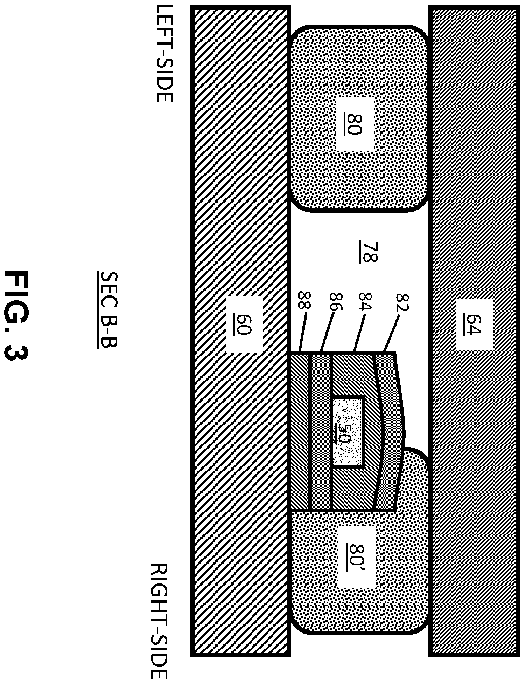

FIG. 3 shows a schematic cross-section side view of an example of the PV solar panel 58 of FIG. 2A, according to the present disclosure. By placing the conductors beneath device 64, a greater exposed area can be dedicated to power generation. PV solar device 64 is glued to insulated substrate 60 at two places with left-side and right-side strips of adhesive 80 and 80', respectively Adhesive strips 80 and 80' can be, for example, about 6-10 mils thick. Gap 78 is defined by device 64 and substrate 60. Copper conductor 50, which can be a "2 oz." copper foil, ribbon, or wire, is disposed in a middle of gap 78. Copper conductor 50 sits on top of an insulated polymer layer 86 (e.g., a polyimide, such as Kapton^{®}). Insulated polymer layer 86 can be, for example, about 1-2 mils thick. Copper conductor 50 is encased within an upper layer 84 of adhesive. Upper adhesive layer 84 can be, for example, about 2-4 mils thick. An upper layer 82 of insulated polymer (e.g., Kapton^{®}) is disposed above upper layer 84 of adhesive. Upper insulated polymer layer 82 can be, for example, about 1-2 mils thick. The insulated copper conductor 50 is partially embedded in the right-side strip of adhesive 80'. Material such as Dupont Pyralux AP is a good choice for Cu-clad Kapton^{®}. This can be laminated with Dupont Pyralux LF, which is a layer of adhesive on Kapton^{®}. This material set is widely available from suppliers and can be fabricated into this assembly. Similar materials are available from other vendors based on Polyimides, as well as PEEK and ETFE plastics. Many adhesives are available to attach such a flexible circuit to the panel. These can be an acrylic adhesive, such as 3M 9460PC or 3M966, or silicone such as NUSIL CV4-1161-5. The thickness of the upper layer of adhesive 84 can be thicker than copper conductor 50.

FIG. 4A shows a schematic plan view of an example of a PV solar device 64, according to the present disclosure. Device 64 comprises a plurality of semiconductor-based, multijunction micro-PV cells 100, 102, 104, ...188 (i.e., by twos) that are defined by a square network of vertical trenches 92 and horizontal trenches 94. Electrical conducting voltage tabs 90 and 90' are disposed at opposite corners of device 64.

FIG. 4B shows a schematic plan view of an example of a PV solar device, illustrating forty-five micro-PV cells 100, 102, 104, ... 188, all connected in series of the device shown in FIG. 4A, according to the present disclosure. Electrically conducting voltage tabs 90 and 90' are disposed at opposite corners of device 64. Electrically conducting voltage tabs 96, 96, 96", etc. interconnect adjacent micro-PV cells 100, 102, and 104, etc., respectively. Electrically conducting voltage tabs 98 and 98' interconnect pairs of corner micro-PV cells 108 to 110, and 178 to 180, respectively.

These voltage tabs can be metal conductors added to the completed PV device for example with wire or ribbon bonding. Alternatively, these conductors could be achieved through multiple steps of patterned insulator and conductors in the wafer fabrication steps.

FIG. 4C shows a schematic plan view of an example of a PV solar device, illustrating a continuous photocurrent path 190, ***I_{device}*,** flowing through the forty-five micro-PV cells 100, 102, 104, ... 188, all connected in series in a serial serpentine fashion, of the device shown in FIG. 4B, according to the present disclosure. For example, using multi-junction cells, if each micro-cell 100 is 1 cm² in size, then each micro-cell 100 would generate about 20 mA of photocurrent. Thus, each micro-cell would produce about 20 mA of photocurrent and add 2 V, for a power output of 0.04 W per micro-cell 100. This would continue across the forty-five micro-PV cells connected in series, so that at the lower right corner the output voltage tab 90' of device 64 would deliver electrical power at 90 V with 20 mA flowing through the circuit, for a power of 1.8 W per device 64. With, for example, eight devices 64, 64', etc. connected in parallel across a single horizontal row of a PV solar panel 58 (see FIG. 2A), then the parallel array of 8 devices would produce 0.16 A at 90 V, or 14 W of electrical power. A solar panel 58 with 5 rows (with 8 devices per row) would produce 0.8 A at 90 V, or 72 W of power. The serial array of 45 micro-PV cells 100, 102, 104, etc. creating 90 V is referred to as a "device", and each sub-unit creating 2V is referred to as a "micro-PV cell" or a "micro-cell". The term "micro-cell" refers to solar cells that are approximately 1 cm² in size (area).

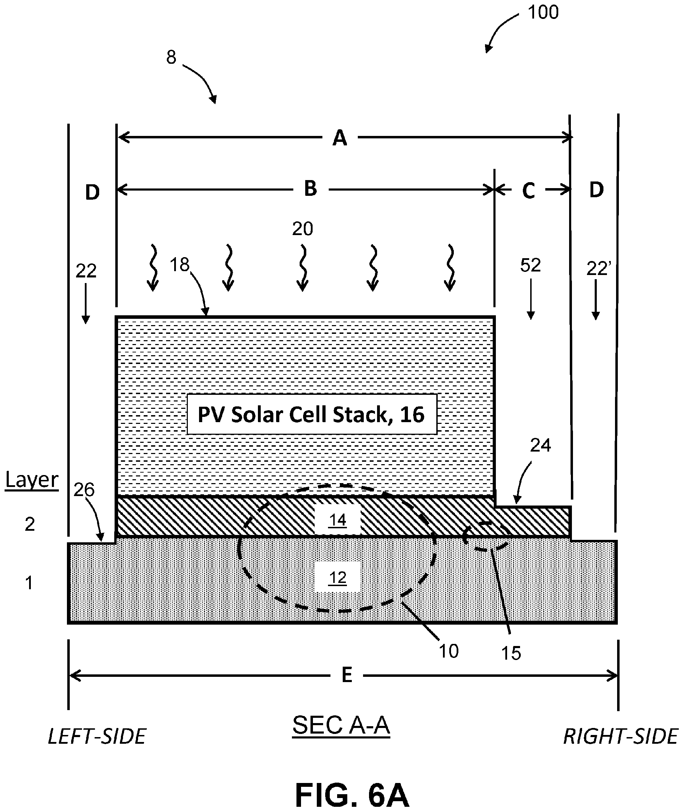

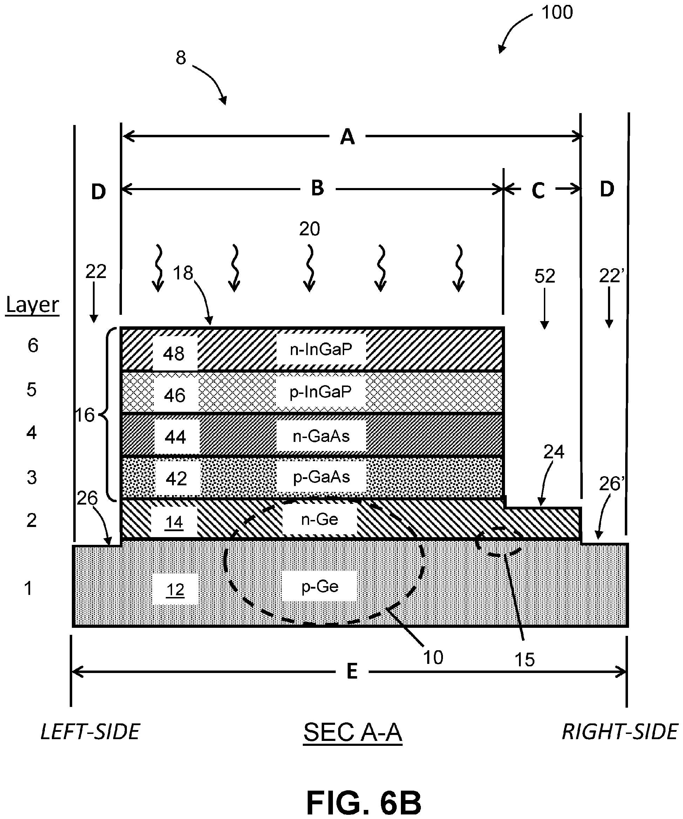

Solar cells may become shadowed on orbit. As they become shadowed, the circuit voltage will reverse bias the cell. Thus shadowing, which is common, will result in reverse biasing solar cell devices by 40V in this example. The breakdown voltage of a triple-junction PV solar cell is ~20V, therefore reverse biasing will likely damage the device. A bypass diode for each solar cell device can prevent this damage and will be discussed further in Fig 6.

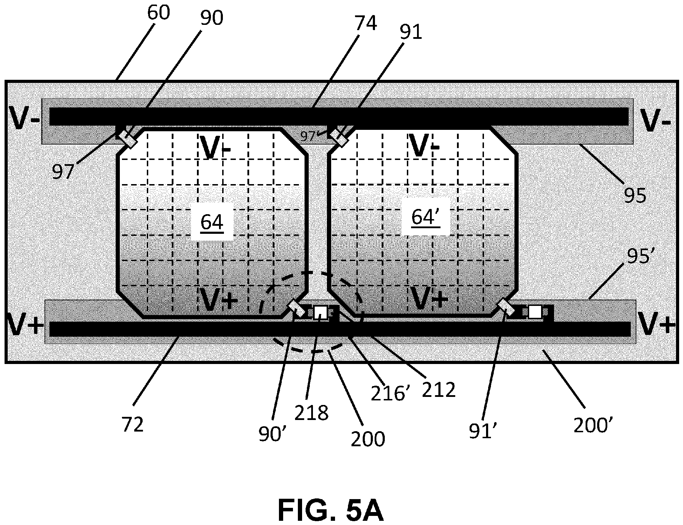

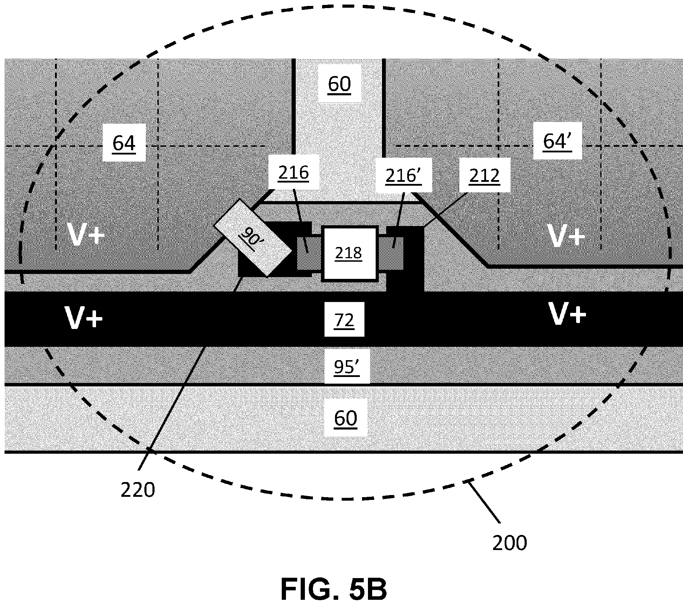

FIG. 5A shows a schematic plan view of an example of a pair of adjacent PV solar devices 64 and 64', according to the present disclosure. The area defined by dashed line circle 200 is enlarged and illustrated in FIG. 5B. The pair of devices 64 and 64' are electrically interconnected via voltage tabs 90 and 91 to extensions 97 and 97', respectively, of the negative stripe 74. The pair of devices 64 and 64' are electrically interconnected via tabs 90' and 91' to positive stripe 72. Electrical stripes 7 and 72 are disposed over polymer strips 95 and 95', respectively. Discrete blocking diode 218 is connected to right-side ribbon 216', which is connected to conductive extension 212 of positive stripe 72.

FIG. 5B shows a schematic, enlarged, plan view of an example of an electrical connection 200 in between the pair of adjacent PV solar devices 64 and 64' shown in FIG. 5A, according to the present disclosure. PV solar device 64 is connected to positive electrical stripe 72 via voltage tab 90', which is connected to conductor 220, which is connected to left-side ribbon 216, which is connected to discrete blocking diode 218, which is connected to right-side ribbon 216', which is connected to conductive extension 212 of positive stripe 72. Blocking diodes located between the PV devices and the bus wiring are an industry standard used to protect these devices in parallel in case one of them is defective.

FIG. 6A shows a schematic cross-section side view of an example of a single, multi-junction micro-PV cell 100 with an integrated monolithic bypass diode 10, according to the present disclosure. P-doped first layer 12, having a width = E, comprises a first semiconductor material and serves as a substrate for fabricating micro-cell 100 upon. N-doped second layer 14, having a width = A, comprises the first semiconductor material and is disposed on the p-doped first layer 12. Multi-junction PV solar cell stack 16, having a width = B, is disposed on n-doped second layer 14. First vertical trench 22, having a width = D, extends down into a left-side of p-doped first layer 12. Second vertical trench 22', having a width = D, extends down into a right-side of p-doped first layer 12. Third vertical trench 52, having a width = C, extends down into n-doped second layer 14 on the right-side on layer 14. Sunlight 20 impinges on upper surface 18 of PV solar cell stack 16 and creates a photocurrent, ***I_{pc}.*** PN junction 15 is disposed in between p-doped first layer 12 and n-doped second layer 14. Bypass diode 10 comprises PN junction 15. First shoulder 26 is disposed on the left-side of n-doped second layer 14, and second shoulder 24 is disposed on the right-side of n-doped second layer 14. Multi-junction PV solar cell stack 16 can comprise 1, or 2 or 3 or more PN junctions. A < E, B < A, C < B, D < B, A = B + C, and E = B + C + 2D.

FIG. 6B shows a schematic cross-section side view of an example of a single, multi-junction micro-PV cell 100 with an integrated monolithic bypass diode 10, according to the present disclosure. This stack shows two solar cell PN junctions on top of a bypass diode PN junction. Both solar cell and bypass junctions have an N-on-P polarity. P-doped first layer 12, having a width = E, comprises germanium (Ge) and serves as a substrate for fabricating micro-cell 100 upon. N-doped second layer 14, having a width = A, comprises Ge and is disposed on the p-doped first layer 12. Multi-junction PV solar cell stack 16, having a width = B, is disposed on n-doped second layer 14. PV solar cell stack 16 comprises four stacked semiconductor layers 42, 44, 46, and 48. P-doped third layer 42, having a width = B, comprises gallium arsenide (GaAs) and is disposed on the n-doped second layer 14. N-doped fourth layer 44, having a width = B, comprises gallium arsenide (GaAs) and is disposed on the p-doped third layer 42. P-doped fifth layer 46, having a width = B, comprises indium gallium phosphide (InGaP) and is disposed on the n-doped fourth layer 44. N-doped sixth layer 48, having a width = B, comprises indium gallium phosphide (InGaP) and is disposed on the p-doped fifth layer 46.

The example shown in FIG. 6B is nearly identical to a typical triple junction solar cell. The difference is the wiring. The negative connection is from the sun facing surface (N-side) as is typical. The positive connection is not from the typical bottom p-side but from the n-side of the bottom PN junction (24). This wiring configuration enable the bottom PN junction to function as a bypass diode. The Ge structure of the triple-junction solar cell is now changed. The Ge layers no longer act as a third solar cell, but, rather, are used to produce a bypass diode 10. The top and middle PN junctions consisting of layers 48 & 46, and 44 and 42, are structured to have the N side of the PN junctions facing towards the sun. Light absorbed in the top and middle PV cells will produce a photocurrent, ***I_{pc},*** flowing down toward the p-doped (Ge) first layer 12. The top and middle cells are joined by tunnel junctions (not shown). Similarly, the bottom p-side of the middle cell will be followed by a tunnel junction connection to the n-doped (Ge) second layer 14. Thus, the photocurrent flows into the n-doped (Ge) second layer 14.

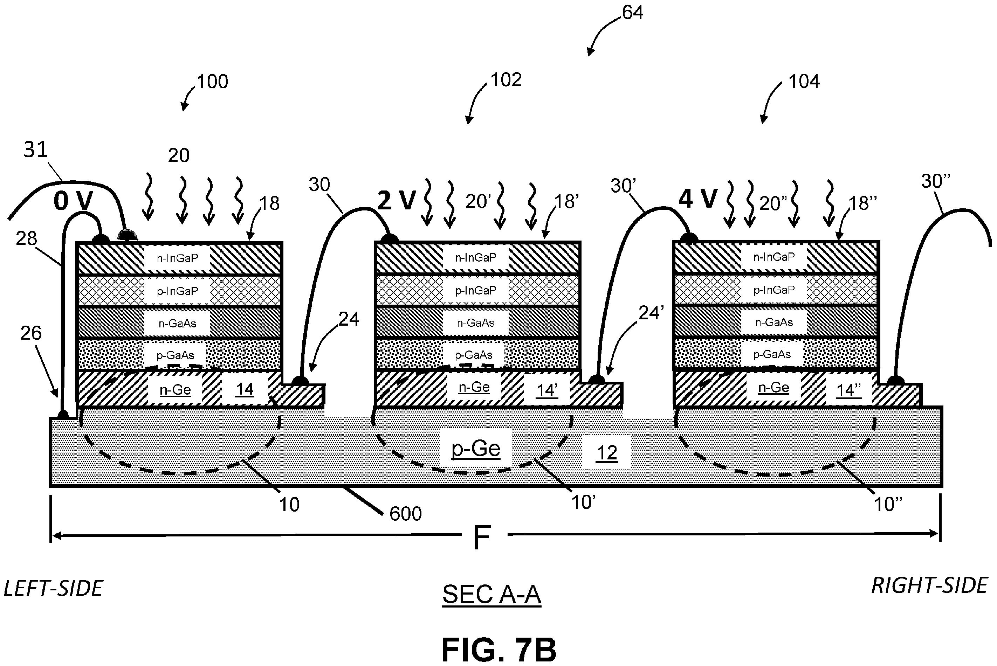

Referring still to FIG. 6B, the Ge wafer (first layer 12) will be etched and fabricated to have each micro-PV cell 100 on its own mesa. Each mesa is an individual multi-junction micro-PV cell 100. The p-Ge first layer 12 is located beneath the n-Ge second layer 14. This PN Ge diode blocks the flow of photocurrent from the multi-junction micro-PV cell 100 from entering the p-Ge first layer 12. The mesa is etched into and through the n-Ge second layer 14. Thus, each multijunction micro-cell 100 produces photocurrent separately. The side of the mesa will have a step edge (shoulder 24) where a portion of the n-Ge second layer 14 is exposed. An electrical connection is made (see FIG. 7B) between the n-Ge second layer 14 and the top surface 18' of the n-type top cell electrode of an adjacent micro-PV cell 102. This allows many multi-junction micro-PV cells 100, 102, 104, etc. to be connected in series to produce higher output voltages. These micro-PVcells 100, 102, 104, etc. are all located on a single, common Ge substrate 12. This common Ge substrate defines the device 64, with many multi-junction micro-PV cells 100, 102, 104, etc. connected in series. Referring still to FIG. 6B, first vertical trench 22, having a width = D, extends into a left-side of p-doped first Ge layer 12. Second vertical trench 22', having a width = D, extends into a right-side of p-doped first germanium layer 12. Third vertical trench 52, having a width = C, extends into n-doped second Ge layer 14 on the right-side on layer 14. Sunlight 20 impinges on upper surface 18 of PV solar cell stack 16. PN junction 15 is disposed in between p-doped first Ge layer 12 and n-doped second Ge layer 14. Bypass diode 10 comprises PN junction 15. First shoulder 26 is disposed on the left-side of n-doped second Ge layer 14, and second shoulder 24 is disposed on the right-side of n-doped second Ge layer 14.

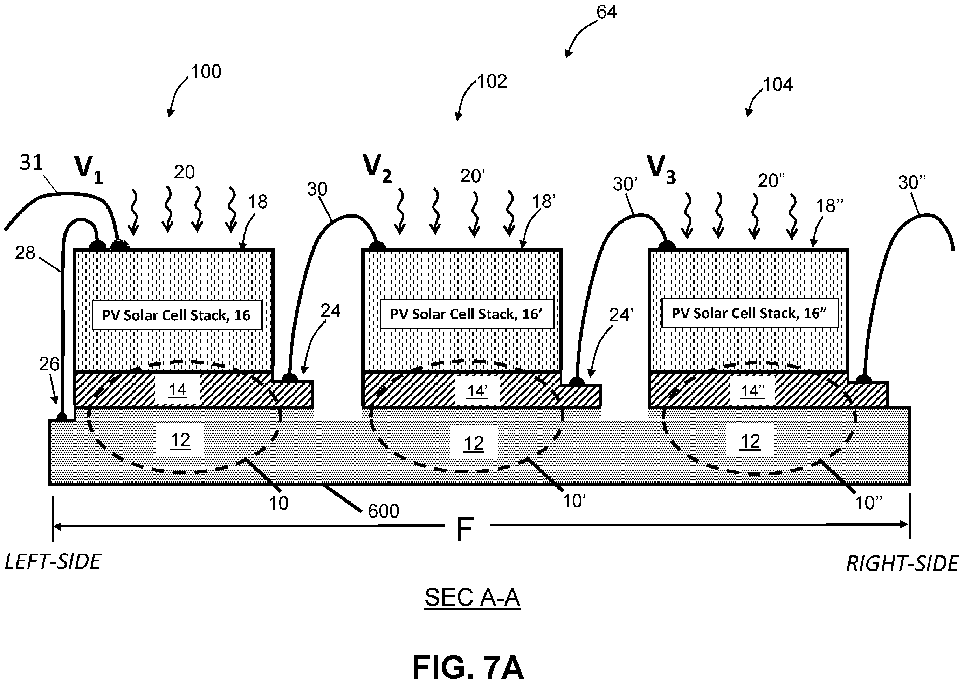

FIG. 7A shows a schematic cross-section side view of an example of a PV solar cell device 64 comprising three, multi-junction micro-PV cells 100, 102, 104 with integrated monolithic bypass diodes 10, 10', 10", all connected in series, according to the present disclosure. P-doped first layer 12, having a width = F, comprising a first semiconductor material is used as a common substrate 600 (i.e., p-doped first layer 12) for supporting all three micro-PV cells 100, 102, 104. First micro-cell 100 comprises a first PV solar cell stack 16, having a width = B, disposed on a n-doped second layer 14, having a width + A. N-doped second layer is disposed on p-doped first layer 12. micro-PV cells 102 and 104 are identical to micro-cell 100, and their description won't be repeated here.

Referring still to FIG. 7A, first conductor 28 connects the first left-side shoulder 26 of p-doped first layer 12 to the upper surface 18 of PV solar cell stack 16. Second conductor 30 connects the right-side shoulder 24 on n-doped second layer 14 to the upper surface 18' of second PV solar cell stack 16' (of micro-cell 102). Third conductor 30' connects the right-side shoulder 24' on n-doped second layer 14' to the upper surface 18" of third PV solar cell stack 16" (of micro-cell 104). Hence, micro-PV cells 100, 102, and 104 are all connected in series. Note: V1 < V2 < V3. Conductor 30" is the positive voltage end of this circuit and extends to an electrical load, which is not shown. Conductor 31 is the negative voltage end of this circuit and extends to the electrical load, which is not shown.

FIG. 7B shows a schematic cross-section side view of an example of a PV solar cell device 64 comprising three, multi-junction micro-PV cells 100, 102, 104 with integrated monolithic bypass diodes, all connected in series, according to the present disclosure. micro-PV cells 100, 102 and 104, and their interconnections, are identical to the micro-PV cells shown in FIG. 7A, with the following difference. PV solar cell stacks 16, 16', and 16" of FIG. 7B are identical to the PV solar stack 16 previously described in FIG. 6B. As such, their details won't be repeated here.

Referring still to FIG. 7B, the multi-junction micro-PV cells 100, 102, 104 each have their own integrated bypass diode 10, 10', 10" built-in, respectively. The p-Ge substrate 12 is located underneath each micro-PV cell 100, 102, 104 and is connected to the **V-** bus (not shown this is accomplished by the added wire 31 alongside conductor 28). The N-Ge second layer 14 of each micro-PV cell is at a more positive voltage. Thus, the Ge PN junction is reverse biased and no photocurrent flows. When any micro-PV cell is shadowed, photocurrent is no longer flowing though the micro-cell. The device then becomes negatively biased from the other illuminated micro-PV cells on the device and the Ge PN junction of the dark micro-cell is forward biased with photocurrent flowing. Circuit photocurrent, ***I_{pc},*** is maintained with the Ge PN bypass diode preventing dangerous reverse bias conditions of a micro-cell. The Ge bypass diodes 10, 10', 10" bypasses all the cells from the **V-** side of the circuit to the dark (shadowed) micro-cell (e.g., micro-cell 102). The output voltage of the circuit will drop when a micro-cell is shadowed. The devices 64, 64', etc. will be protected and when illumination returns, the output voltage and power will return. In other words, a shadowed micro-cell 100 is at risk of having a dangerous reverse bias of the circuit minus the dark micro-cell or micro-PV cells. Thus, the example of a device with 45 microcells could have one dark micro-cell with 88V reverse biased across it. The bypass diode will reduce this reverse bias to the voltage of the bypass diode which is ~0.2V for a Ge diode. The bypass junction composed of a Ge PN junction is similar to a conventional multijunction solar cell and readily formed. The Ge PN junction may have limited capability as a bypass diode. The Ge bypass diode would need to not be photoactive. Also, the bypass diode will need a reverse breakdown voltage greater than the circuit voltage. When operating all three micro-PV cells in Fig 7B are operating bypass diode 10" will be reverse biased by 4V. In real applications, the circuit voltage will be 20V, 100V, or higher. It is difficult to have a Ge PN junction with a breakdown voltage at this level. A bypass diode made from GaAs or InGaP materials will have a greater breakdown voltage than Ge. Thus, second layer 14 could be replaced with a GaAs or InGaP PN junction. Exchanging a p-Ge first layer 12 for a semi-insulated (SI) GaAs first layer 12 further improves the protection and operation of the circuit.

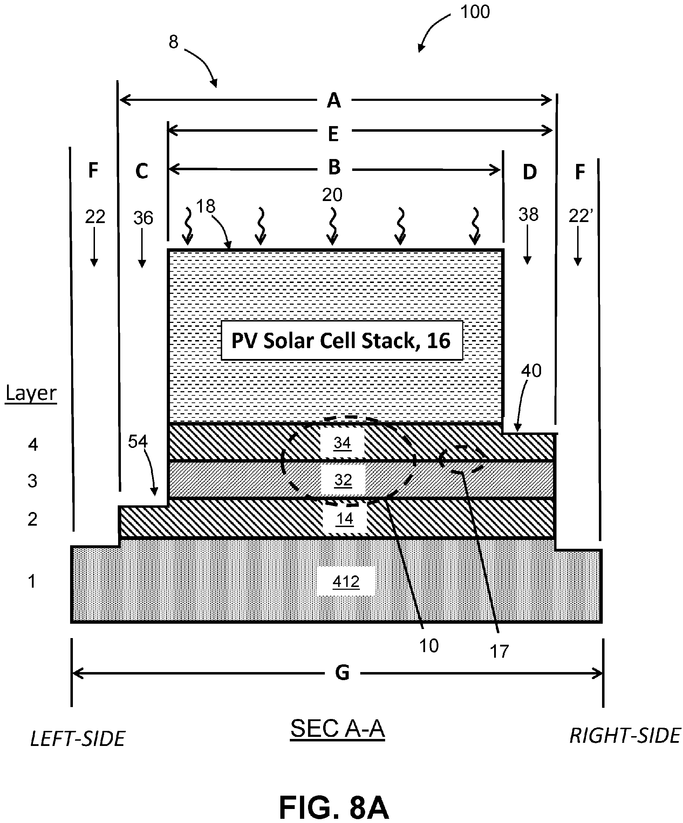

FIG. 8A shows a schematic cross-section side view of an example of a single, multi-junction micro-PV cell 100 with an integrated monolithic bypass diode 10, according to the present disclosure. Semi-insulated (SI) first layer 412, having a width = G, comprises a first semiconductor material and serves as a substrate for fabricating micro-cell 100 upon. The change to a semi-insulated substrate (first SI layer 412) prevents photocurrent from flowing between adjacent micro-PV cells 100, 102, 104, etc. N-doped second layer 14, having a width = A, comprises the first semiconductor material and is disposed on the SI first layer 412. P-doped third layer 32, having a width = E, comprises a second semiconductor material and is disposed on the n-doped second layer 14. N-doped fourth layer 34, having a width = E, comprises the second semiconductor material and is disposed on the p-doped third layer 32. Multi-junction PV solar cell stack 16, having a width = B, is disposed on n-doped fourth layer 34 and can comprise 1 or 2 or 3 PN junctions.

Referring still to FIG. 8A, first vertical trench 22, having a width = F, extends into a left-side of SI first layer 412. Second vertical trench 22', having a width = F, extends into a right-side of SI first layer 412. Third vertical trench 36, having a width = C, extends into n-doped second layer 14 on the right-side on layer 14. Fourth vertical trench 38, having a width = D, extends into n-doped fourth layer 34 on the right-side on layer 34. Sunlight 20 impinges on upper surface 18 of PV solar cell stack 16. PN junction 17 is disposed in between p-doped third layer 32 and n-doped fourth layer 34. Bypass diode 10 comprises PN junction 17. First shoulder 26 is disposed on the left-side of SI first layer 412, and second shoulder 26' is disposed on the right-side of SI first layer 12. Third shoulder 54 is disposed on the left-side of n-doped second layer 14. Fourth shoulder 40 is disposed on the right-side of n-doped fourth layer 34. Multi-junction PV solar cell stack 16 can comprise 1, 2, or 3 PN junctions. A < E, B < A, C < B, D < B, E < G, E = B + D, A = C + B + D, and G = B + C+ D + 2F.

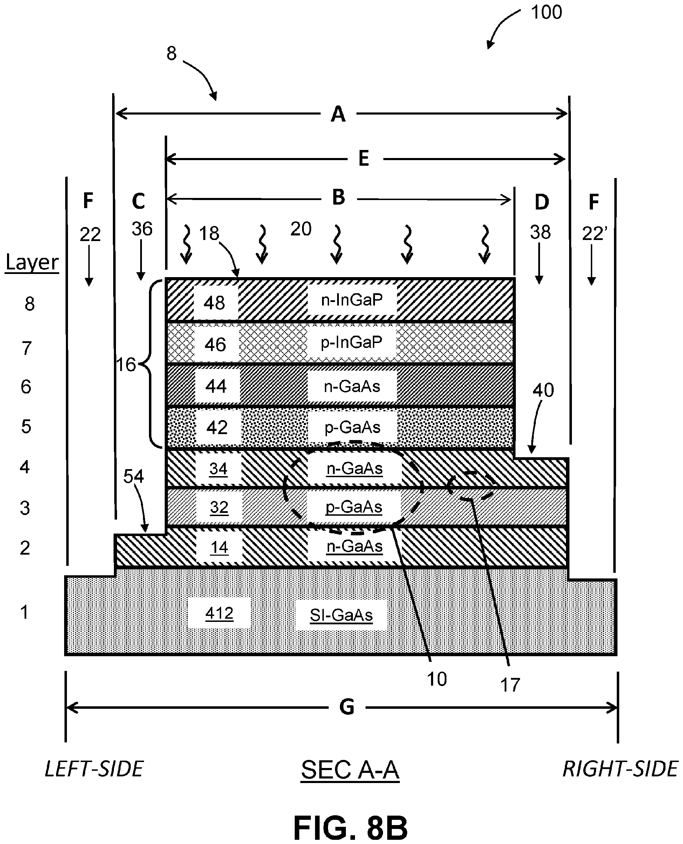

FIG. 8B shows a schematic cross-section side view of an example of a single, multi-junction micro-PV cell 100 with an integrated monolithic bypass diode, 10 according to the present disclosure. Multi-junction PV solar cell stack 16, having a width = B, is disposed on n-doped fourth layer 34 and comprises four semiconductor layers 42, 44, 46, and 48. P-doped fifth layer 42, having a width = B, comprises gallium arsenide (GaAs) and is disposed on the n-doped GaAs fourth layer 34. N-doped sixth layer 44, having a width = B, comprises gallium arsenide (GaAs) and is disposed on the p-doped GaAs fifth layer 42. P-doped seventh layer 46, having a width = B, comprises indium gallium phosphide (InGaP) and is disposed on the n-doped GaAs sixth layer 44. N-doped eighth layer 48, having a width = B, comprises indium gallium phosphide (InGaP) and is disposed on the p-doped InGaP seventh layer 46.

Referring still to FIG. 8B, this example will achieve higher breakdown voltages, and each micro-PV cell 100 is independently bypassed. This is accomplished by using a Semi-Insulated GaAs substrate 412. Each micro-cell 100 is an InGaP + GaAs multi-junction Non P micro-PV cell. The bypass diode 10 is an N on P GaAs diode. Each mesa has micro-PV cell 100 is electrically connected in parallel to bypass diode 10. If micro-PV cell 100 does not flow photocurrent, then bypass diode 10 will allow the photocurrent to flow. The substrate (first SI layer 412) can be low-doped or semi-insulated GaAs to prevent photocurrent flow in the substrate (first layer 412). Note that shoulder 40 and 54 are used for electrical connections to adjacent micro-PV cells. The current from across the micro-cell (~1cm²) moves laterally to these connection points. The sheet resistance of layer 34 and 14 therefore needs to be low to have low voltage loss. The mobility of n-GaAs is far higher than p-GaAs resulting in far lower sheet resistance of a n-GaAs layer to carrying current laterally. Connection 54 could be made to layer 32 but would have a large voltage loss across the p-GaAs layer 32. By adding a tunnel junction and n-GaAs layer 14 this resistance and voltage drop are reduced.

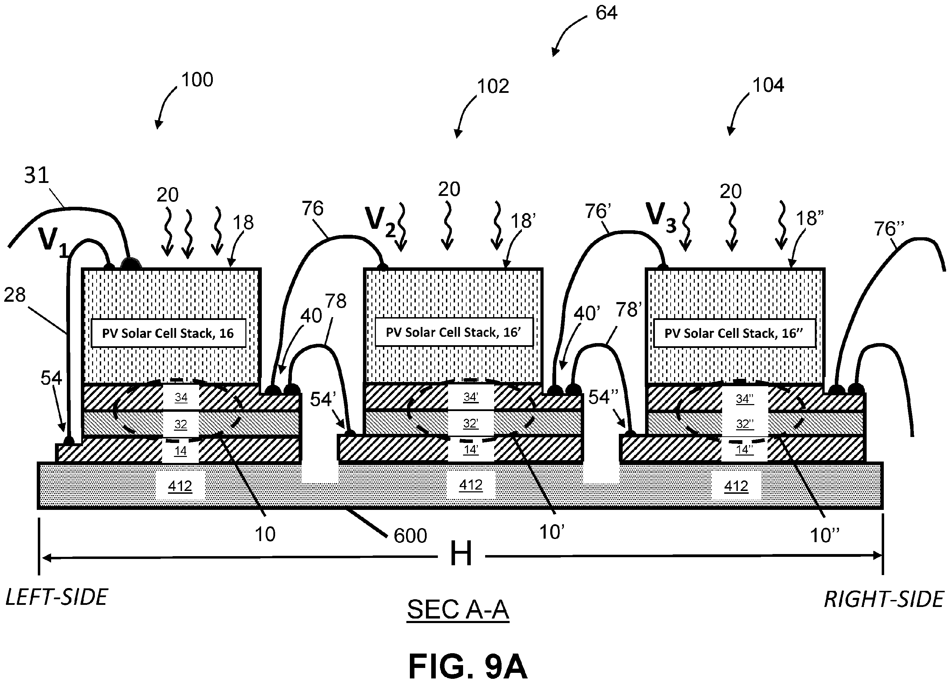

FIG. 9A shows a schematic cross-section side view of an example of a PV solar cell device 64 comprising three, multi-junction micro-PV cells 100, 102, 104 with integrated monolithic bypass diodes 10, 10', 10", respectively, all connected in series, according to the present disclosure. Each micro-PV cell 100, 102, 104 comprises a design that is identical to that shown in FIG. 8A, with the exception being that first SI semiconductor layer 412 extends across the base of all three micro-PV cells 100, 102, 104 (i.e., a common substrate 600). In FIG. 9A, first conductor 28 interconnects third shoulder 54 of first micro-cell 100 to the upper surface 18 of PV solar cell stack 16. Second conductor 76 interconnects fourth shoulder 40 of micro-cell 100 to the upper surface 18' of second micro-cell 102. Third conductor 78 interconnects fourth shoulder 40 to third shoulder 54' of second micro-cell 102. Conductor 76 carries the photocurrent between series connected solar cells, while conductor 78 connects micro-PV cell 100 to the bypass diode 10'. These interconnections are repeated for the next set of connections between second micro-cell 102 and third micro-cell 104, which are all connected in series. Note: V1 < V2 < V3.

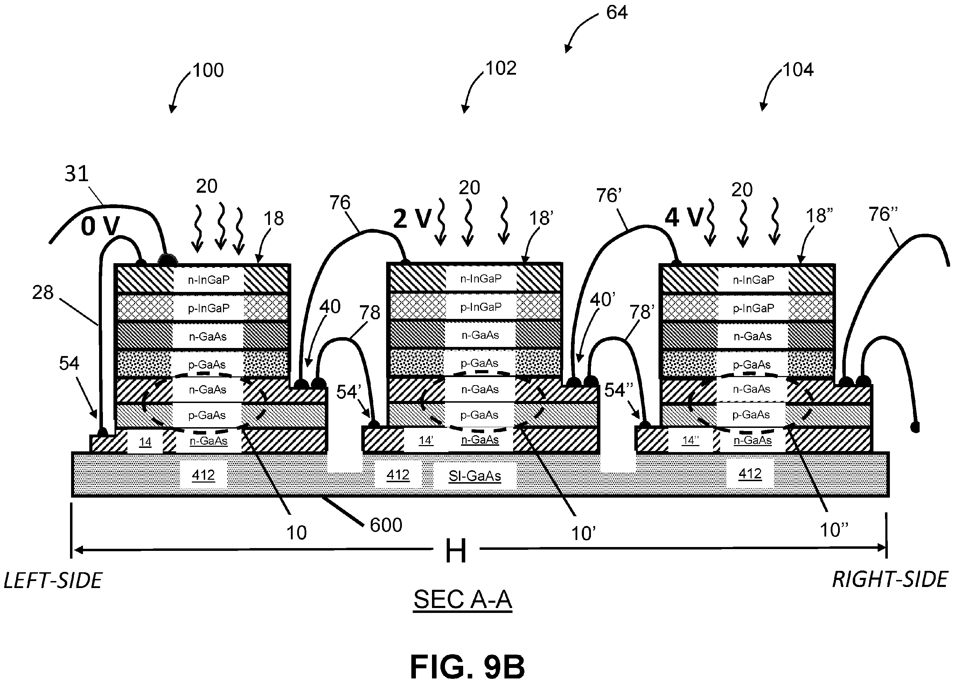

FIG. 9B shows a schematic cross-section side view of an example of a PV solar cell device 64 comprising three, multi-junction micro-PV cells 100, 102, 104 with integrated monolithic bypass diodes, all connected in series, according to the present disclosure. micro-PV cells 100, 102 and 104, and their interconnections, are identical to the micro-PV cells shown in FIG. 9A, with the following difference. PV solar cell stacks 16, 16', and 16" of FIG. 9B are identical to the PV solar stack 16 previously described in FIG. 8B. As such, their details won't be repeated here.

The wiring between micro-PV cells and bypass diodes can be achieved by wafer fabrication processes, by wire or ribbon bonding processes, printed metals, or other approaches known to device manufacturing. Each micro-PV cell 100, 102, 104 has a GaAs PN bypass diode 10, 10', 10", respectively, below the PV solar cell stack 16.

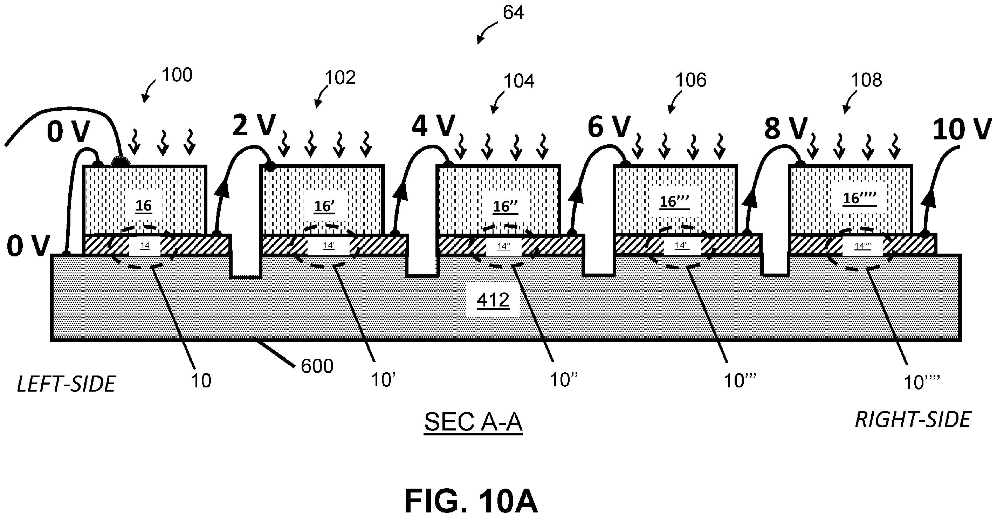

FIG. 10A shows a schematic cross-section side view of an example of a PV solar cell device 64 comprising five, multi-junction micro-PV cells 100, 102, 104, 106, and 108 with integrated monolithic bypass diodes 10, 10', 10", 10‴, 10"", respectively, all connected in series, according to the present disclosure. Each of the five micro-PV cells 100, 102, 104, 106, and 108 have the same structure and electrical interconnections, which is identical to that previously described in FIGS. 6A and 7A, and won't be discussed further here. With each micro-cell generating about 2 Volt per cell, the final voltage of the last micro-cell 108 in the series of five micro-PV cells 100, 102, 104, 106, and 108 is equal to 10 V when all micro-PV cells are fully illuminated with light.

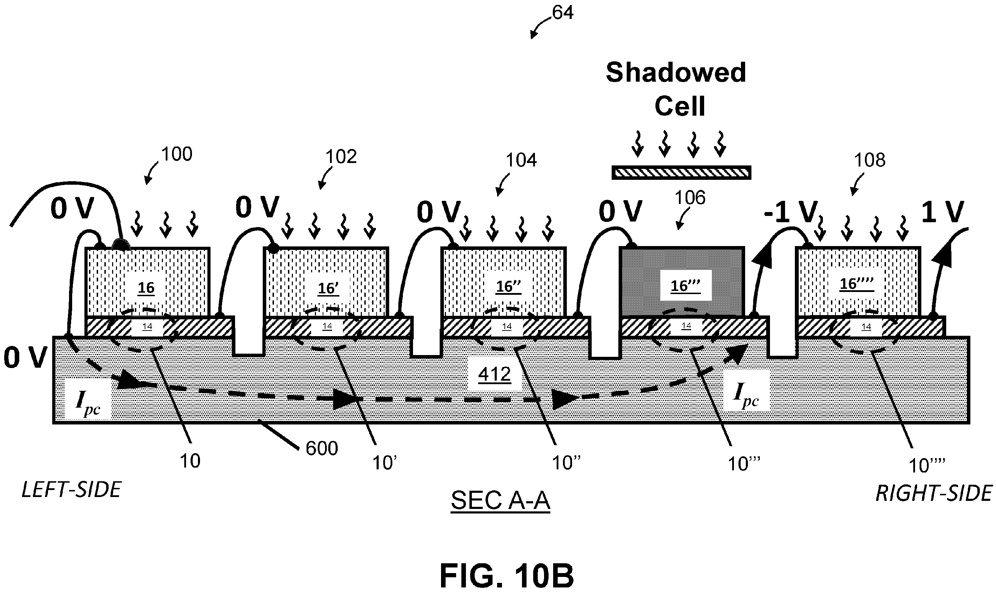

FIG. 10B shows a schematic cross-section side view of an example of a PV solar cell device 64 comprising five, multi-junction micro-PV cells 100, 102, 104, 106, and 108 with integrated monolithic bypass diodes 10, 10', 10", 10‴, 10"", respectively, all connected in series, with a single, shadowed micro-PV cell 106, according to the present disclosure. In this example, bypass diode 10‴ is activated when the fourth micro-cell 106 is shadowed. Bypass diode 10‴ prevents reverse biasing of the shadowed micro-cell 106 in this situation, which causes the photocurrent, ***I_{pc},*** to bypass flowing through shadowed micro-cell 106. The p-Ge SI first layer 412 is common to all the bypass diodes. Thus, all the micro-PV cells from the V- side are bypassed up to the dark micro-cell. In this example the bypass current follows the dashed arrow line through the p-Ge SI first layer 412 bypassing micro-cell 100, 102, 104, 106. The bypass current flows through the p-Ge SI first layer 412 and then the dark micro-cell 106 forward biases the 10" and the bypass current then transitions to the remaining illuminated micro-PV cells. In this example, that is micro-cell 108. With the V negative assumed to be a 0V then the voltage drop of the bypass diode results in a negative voltage at the negative side of micro-cell 108. If the bypass diode is GaAs the voltage will be near -1V. The illuminated micro-cell 108 then adds 2V resulting in a circuit producing 1V.

This is a far lower voltage and far lower output power. However, this is only the case when shadowed. The circuit is entirely protected, thus when the shadowing is removed the circuit will return to full power. And in this novel configuration, the 90V circuit has an area of 150 cm², which is far smaller than conventional solar arrays.

In examples with a Semi-Insulated substrate each micro-PV cell has one wire on the negative and positive end carrying the photocurrent. Bypass current is carried through substrate 412 to the darkened cell. A SI substrate 412 does not allow current to flow, thus a third conductor 78 is needed between micro-PV cells. Each bypass diode is then independent of substrate 412 and is easier to use GaAs or InGaP materials to make high quality bypass diodes with low leakage currents and high breakdown voltages. Each bypass diode is now connected to adjacent cells. When the circuit is operating normally each bypass diode will be reverse biased by the micro-cell which is near 2V. Any reverse bias leakage current through the bypass diode reduces power output of the circuit and minimizing it is important. The SI substrate 412 results in reverse biasing of the bypass diode at 2V where leakage currents are low. The configuration with the p-Ge substrate 412 results in reverse biasing of bypass diodes as high as the circuit voltage, leading to much greater leakage currents.

In some examples, a coating of metal on a backside of the p-doped first layer 12 is not used or required.

In some examples, each micro-PV cell has a buried Ge PN junction that is a bypass diode.

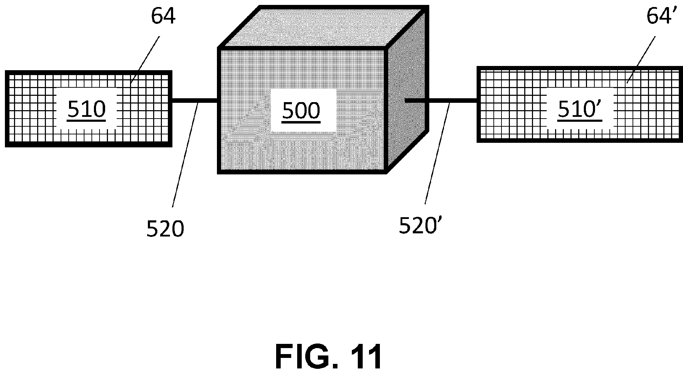

FIG. 11 shows a schematic perspective view of an example of an extraterrestrial satellite 500 with a pair of PV solar panels 510, 510' that are attached to satellite 500 with a pair of structural members 520, 520', respectively, wherein each PV solar panel 510, 510' comprises a plurality of multi-junction PV solar devices 64, 64', etc. with integrated monolithic bypass diodes (that are too small to be seen), according to the present disclosure. PV solar devices 64, 64', etc. are fabricated using the same configurations and semiconductor process that are disclosed herein.

An example of method steps for fabricating a PV solar panel 58 that uses micro-PV cell 100, 102, 104, etc. with integrated monolithic bypass diodes 10, 10', and 10", respectively, (with reference to FIGS. 6A and 7A) is as follows:
Step 300 Provide a p-doped Ge wafer;
Step 310 Form a n-doped Ge second layer above the p-doped Ge wafer;
Step 320 Fabricate a multi-junction PV solar cell stack with 1-3 PN junctions;
Step 330 Epitaxially etch pads for subsequent ribbon bonding;
Step 340 Mesa cut trenches through the n-doped Ge second layer down into p-doped Ge wafer;
Step 350 Deposit frontside metal on the n-doped Ge second layer;
Step 360 Ribbon bond a plurality of micro-PV cells in series;
Step 370 Dice individual devices from the fabricated p-doped Ge wafer into a plurality of cropped squares;
Step 380 Weld interconnects in between the plurality of cropped squares;
Step 390 Assemble the interconnected devices into a solar panel; and
Step 400 Encapsulate the assembled solar panel.

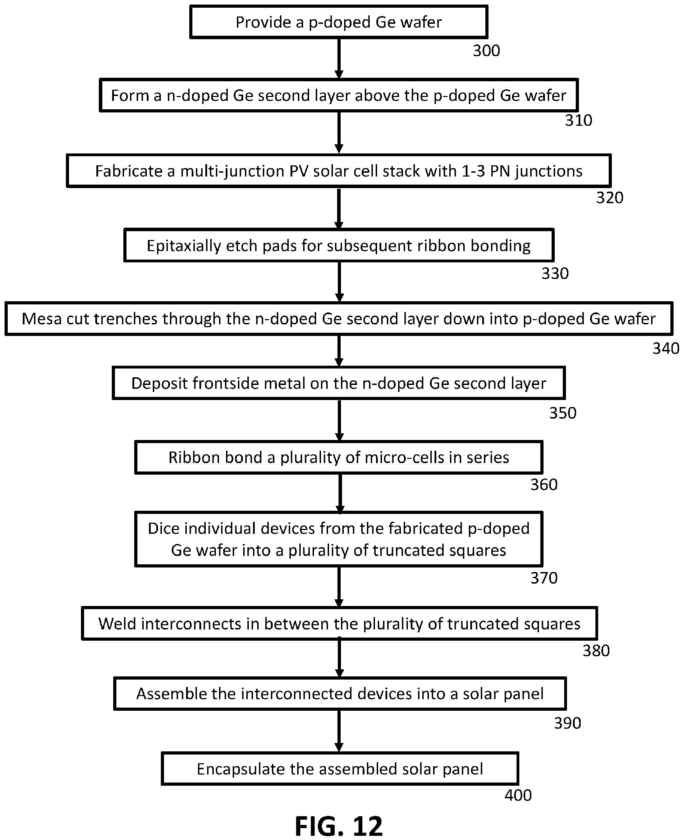

FIG. 12 shows an example of a flow chart illustrating the steps 300 to 400 outlined above for fabricating a PV solar panel 58.

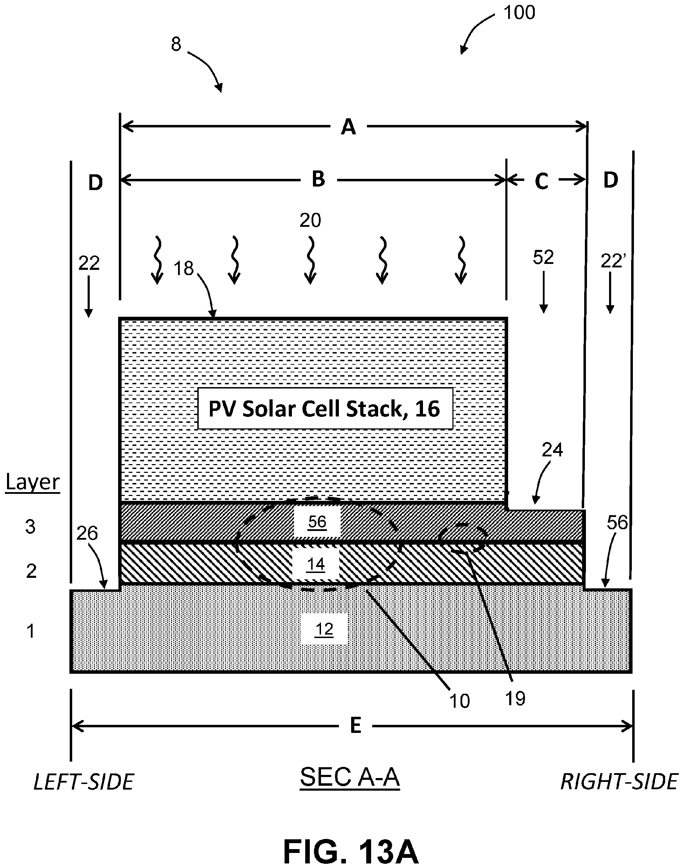

FIG. 13A shows a schematic cross-section side view of an example of a single, multi-junction micro-PV cell 100 with an integrated monolithic bypass diode 10, according to the present disclosure. This example is identical to that shown in FIG. 6A, with the following differences.

An extra semiconductor layer (layer 56) is inserted in between the second layer 14 and the PV solar cell stack 16. In this example, the second layer 14 can comprise a p-doped *second* semiconductor material, and extra layer 56 can comprise an n-doped layer of the same *second* semiconductor material. PN junction 19 can be seen, which is located at the intersection of the second layer 14 and the third layer 56. Multi-junction PV solar cell stack 16 can comprise 1 or 2 or 3 PN junctions.

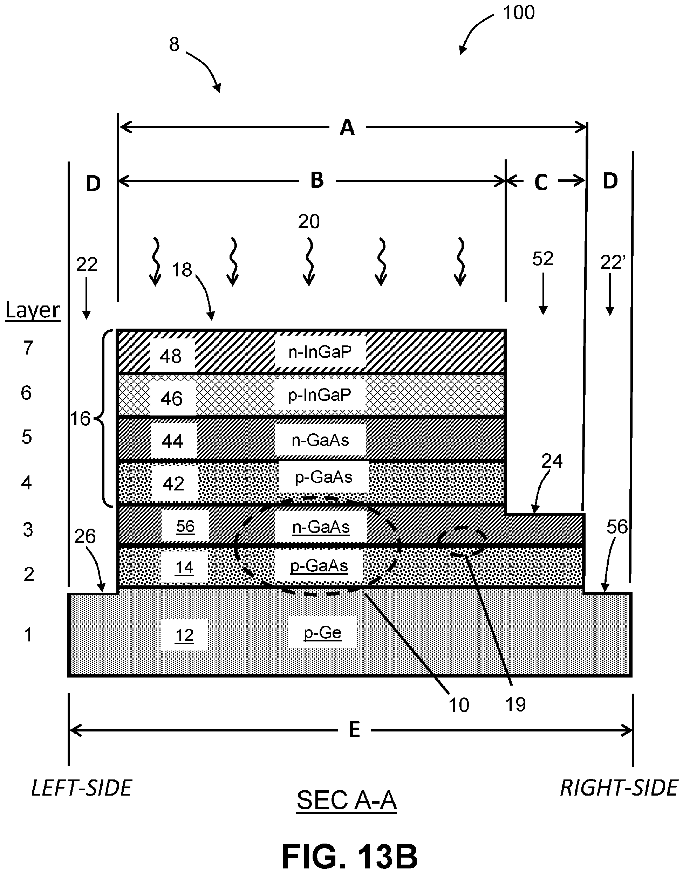

FIG. 13B shows a schematic cross-section side view of an example of a single, multi-junction micro-PV cell 100 with an integrated monolithic bypass diode 10, according to the present disclosure. This example is identical to that shown in FIG. 6B, with the following difference.

Here, the extra layer (i.e., third layer 56) is inserted in between the second layer 14 and the bottom layer 42 of PV solar cell stack 16. In this example, the second semiconductor material is GaAs.

First layer 12 is p-Ge, second layer 14 is p-GaAs (not n-Ge, as in previous examples), and third layer 56 is n-GaAs. The total number of layers increases to seven, because of the insertion of the extra layer 56 into micro-PV cell 100. Bypass diode 10 comprises GaAs PN junction 19, which comprises the intersection of the p-GaAs second layer 14 and the n-GaAs third layer 56.

Referring still to FIG. 13B, the use of a GaAs bypass diode 10 in FIG. 13B provides a much higher breakdown voltage than the Ge PN diode 10 previously used in FIG. 6B. To prevent light from illuminating the GaAs bypass diode 10, the GaAs second micro-PV cell (i.e., layers 42 and 44) can be sufficiently thick to effectively block incident light 20 from reaching GaAs bypass diode 10. Alternatively, or additionally, a Distributed Bragg Reflector (DBR) (not shown) can be inserted above the GaAs bypass diode 10 to prevent unwanted illumination of the GaAs bypass diode 10. The p-GaAs of the bypass diode 10 is able to flow photocurrent into the Ge substrate 12. This can be achieved with the p-Ge substrate layer 12.

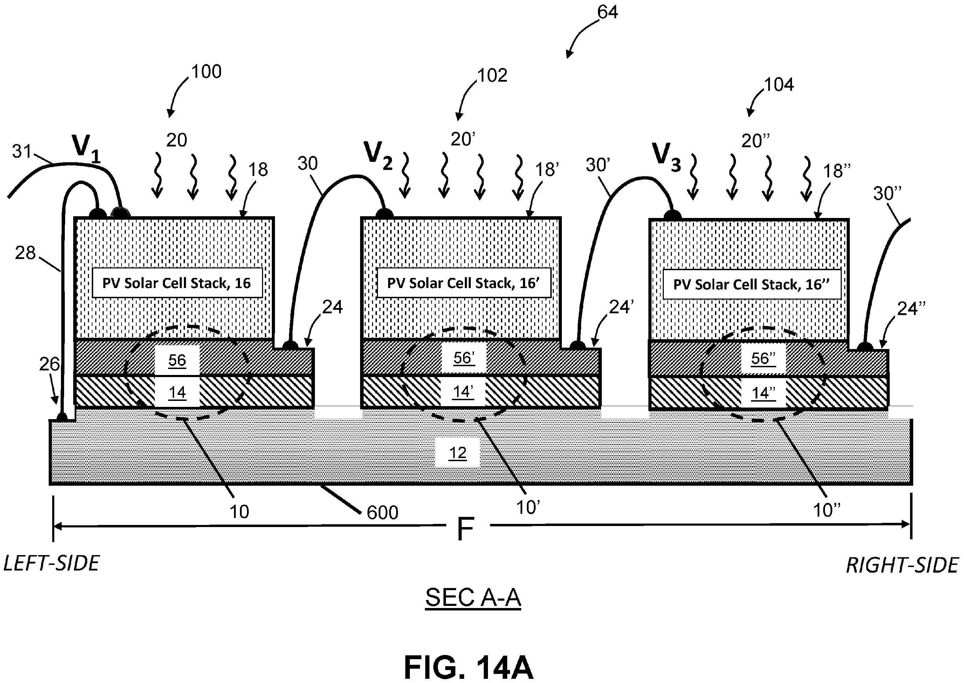

FIG. 14A shows a schematic cross-section side view of an example of a PV solar cell device 63 comprising three, multi-junction micro-PV cells 100, 102, 104 with integrated monolithic bypass diodes 10, 10', 10", all connected in series, according to the present disclosure. FIG. 14A is identical to FIG. 7A, with the following difference. An extra semiconductor layer (layer 56) is inserted in between the second layer 14 and the PV solar cell stack 16. In this example, the second layer 14 can comprise a p-doped *second* semiconductor material, and layer 56 can comprise an n-doped layer of the same *second* semiconductor material.

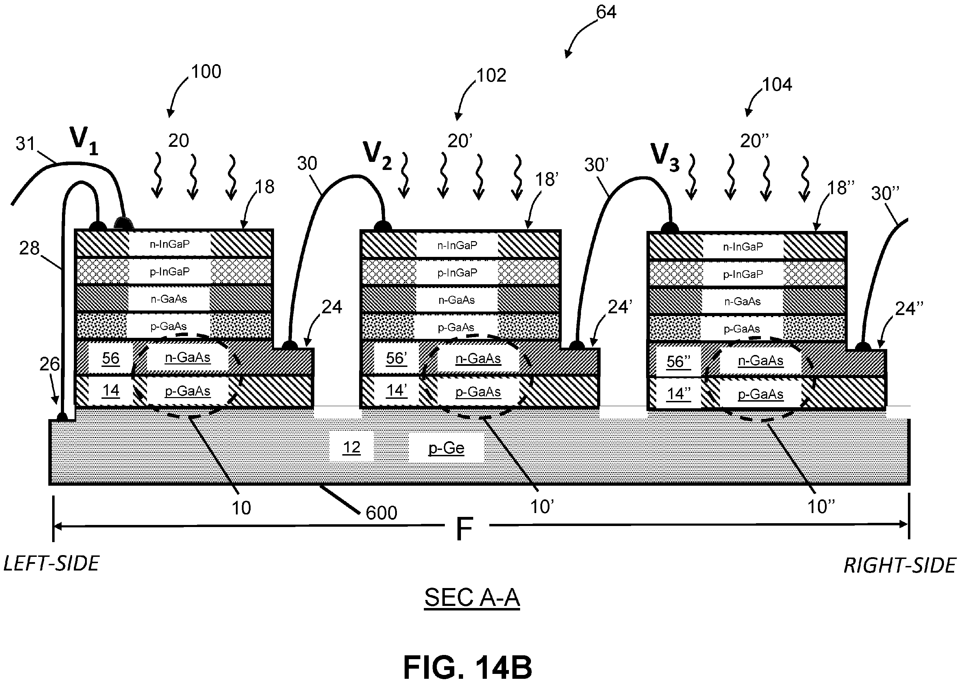

FIG. 14B shows a schematic cross-section side view of an example of a PV solar cell device 63 comprising three, multi-junction micro-PV cells 100, 102, 104 with integrated monolithic bypass diodes 10, 10', 10", all connected in series, according to the present disclosure. FIG. 14B is identical to FIG. 7B, with the following difference. In this example, the second semiconductor material is GaAs. Here, an extra n-GaAs layer 56 is inserted in between a p-doped GaAs second layer 14 and the p-GaAs fourth layer 42. The total number of layers increases to seven, because of the insertion of the extra layer 56 into micro-PV cell 100.

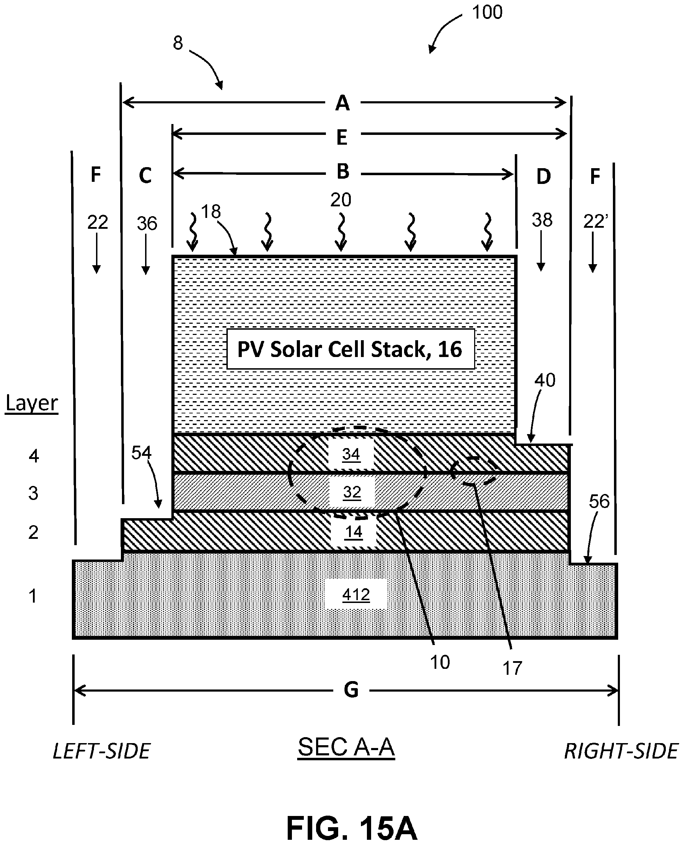

FIG. 15A shows a schematic cross-section side view of an example of a single, multi-junction micro-PV cell 100 with an integrated monolithic bypass diode 10, according to the present disclosure. Semi-insulated (SI) first layer 412, having a width = G, comprises a first semiconductor material and serves as a substrate for fabricating micro-cell 100 upon. N-doped second layer 14, having a width = A, comprises a second semiconductor material and is disposed on the SI first layer 12. P-doped third layer 32, having a width = E, comprises a p-doped second semiconductor material and is disposed on the n-doped second layer 14. N-doped fourth layer 34, having a width = E, comprises the second semiconductor material and is disposed on the p-doped third layer 32. Multi-junction PV solar cell stack 16, having a width = B, is disposed on n-doped fourth layer 34 and stack 16 can comprise 1 or 2 or 3 PN junctions. The other features of FIG. 15A are identical to FIG. 8A and won't be repeated here.

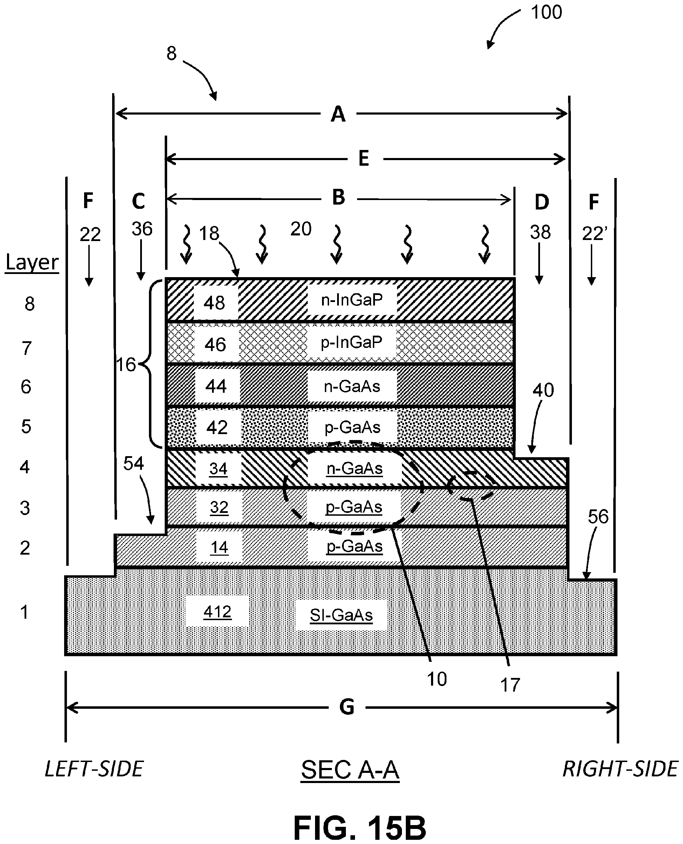

FIG. 15B shows a schematic cross-section side view of an example of a single, multi-junction micro-PV cell 100 with an integrated monolithic bypass diode 10, according to the present disclosure. This example is identical to FIG. 8B, with the following difference. In this example, the first and second semiconductor material are both GaAs. The second layer 14 comprises p-GaAs (not n-GaAs, as in FIG. 8B).

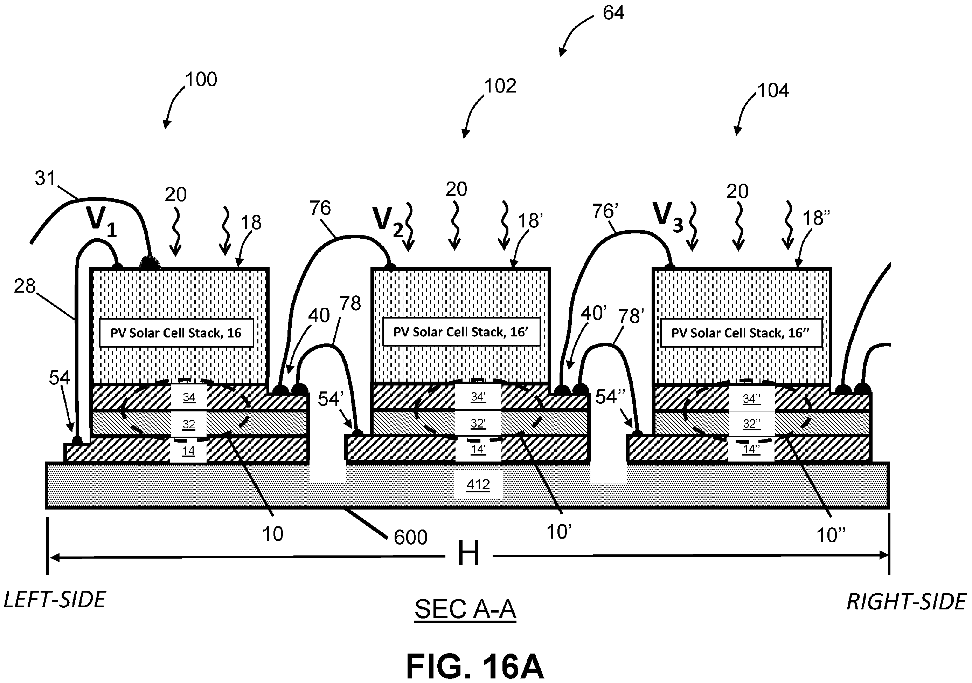

FIG. 16A shows a schematic cross-section side view of an example of a PV solar cell device 64 comprising three, multi-junction micro-PV cell 100, 102, 104 with integrated monolithic bypass diodes 10, 10', 10", respectively, all connected in series, according to the present disclosure. Each micro-cell 100, 102, 104 comprises a design that is identical to that shown in FIG. 8A, with the exception being that first SI semiconductor layer 12 extends across the base of all three micro-PV cells 100, 102, 104 (i.e., a common substrate 600). In FIG. 16A, first conductor 28 interconnects third shoulder 54 of first micro-cell 100 to the upper surface 18 of PV solar cell stack 16. Second conductor 76 interconnects fourth shoulder 40 of micro-cell 100 to the upper surface 18' of second micro-cell 102. Third conductor 78 interconnects fourth shoulder 40 to third shoulder 54' of second micro-cell 102. These interconnections are repeated for the next set of connections between second micro-cell 102 and third micro-cell 104, which are all connected in series. Note: V1 < V2 < V3. In this example, second layers 14, 14', 14" comprise a p-doped second semiconductor material.

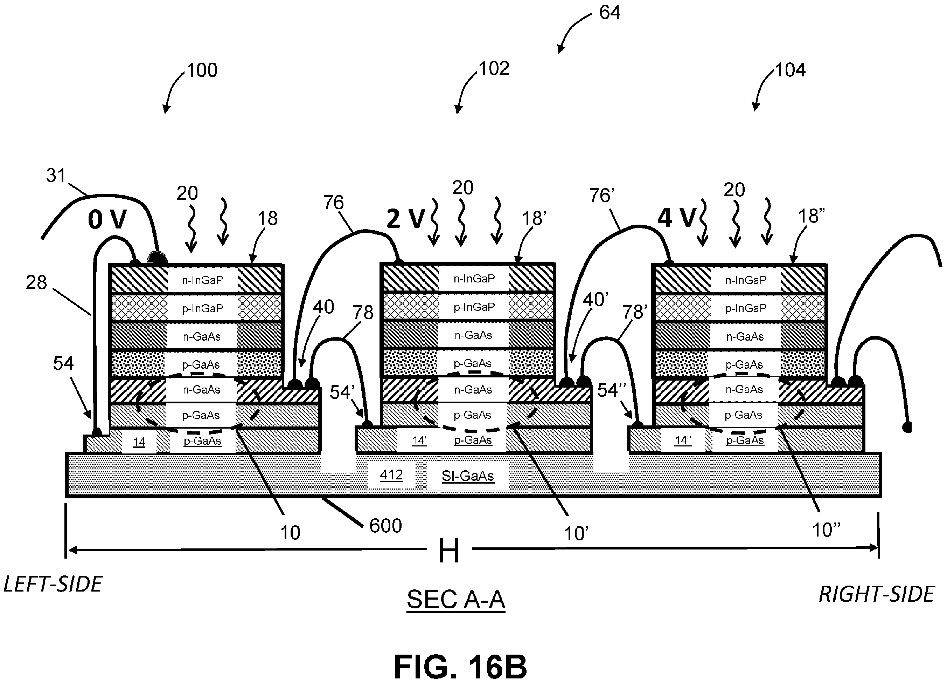

FIG. 16B shows a schematic cross-section side view of an example of a PV solar cell device 64 comprising three, multi-junction micro-PV cell 100, 102, 104 with integrated monolithic bypass diodes, all connected in series, according to the present disclosure. micro-PV cells 100, 102 and 104, and their interconnections, are identical to the micro-PV cells 100, 102, 104 shown in FIG. 9A, with the following difference. PV solar cell stacks 16, 16', and 16" of FIG. 16B are identical to the PV solar stacks 16, 16', 16" previously described in FIG. 9B. In this example, second layers 14, 14', 14" comprise p-doped GaAs (not n-GaAs, as in FIG. 9B).

In some examples, a surface area exposed to the Sun (or other light source) of an individual micro-PV cell can range from about 0.5 to about 2 cm². In some examples, the surface area of an individual micro-PV cell can be less than or equal to about 1 cm².

In some examples, a surface area exposed to the Sun (or other light source) of an individual PV device can range from about 20 to about 100 cm². In some examples, the surface area of an individual PV device can be greater than or equal to about 45 cm².

Further, the disclosure comprises the following examples:
Example 1. A photovoltaic (PV) micro-PV cell, comprising: a left-side and a right-side; a first layer comprising a p-doped first semiconductor material; a second layer, comprising a n-doped first semiconductor material, disposed on the first layer; a multi-junction micro-PV cell stack disposed on a portion of the second layer; a first trench extending down into the first layer, disposed on a left-side of the micro-PV cell; a second trench extending down into the first layer, and disposed on the right-side of the micro-PV cell; a third trench, disposed adjacent to the second trench and extending down into the second layer, wherein the third trench is disposed on the right-side of the micro-PV cell adjacent to a left-side of the second trench; a left-side first shoulder disposed on the left-side of the micro-PV cell at a bottom of the first trench; a right-side second shoulder disposed on the right-side of the micro-PV cell at a bottom of the third trench; and an integrated monolithic bypass diode comprising a buried PN junction disposed in between the second layer and the first layer.
Example 2. The micro-PV cell of example 1, wherein the multi-junction micro-PV cell stack comprises 1 or 2 or 3 PN junctions.
Example 3. The micro-PV cell of example 1 or 2, wherein no metal is disposed on a backside of the first layer.
Example 4. The micro-PV cell of any of examples 1, 2, or 3, further comprising: a third layer comprising a p-doped second semiconductor material, disposed on the second layer; a fourth layer comprising a n-doped second semiconductor material, disposed on the third layer; a fifth layer comprising a p-doped third semiconductor material, disposed on the fourth layer; and a sixth layer comprising a n-doped third semiconductor material, disposed on the fifth layer.
Example 5a. The micro-PV cell of example 4, wherein: the first layer comprises p-Ge; the second layer comprises n-Ge; the third layer comprises p-GaAs; the fourth layer comprises n-GaAs; the fifth layer comprises p-InGaP; and the sixth layer comprises n-InGaP.
Example 5b. The micro-PV cell of example 4, wherein: the first layer comprises p-Ge; the second layer comprises n-GaAs on p-GaAs; the third layer comprises p-GaAs; the fourth layer comprises n-GaAs; the fifth layer comprises p-InGaP; and the sixth layer comprises n-InGaP.
Example 6. A photovoltaic (PV) micro-PV cell, comprising: a left-side and a right-side; a first layer comprising a first semi-insulated semiconductor material; a second layer comprising a n-doped first semiconductor material, disposed on the first layer; a third layer comprising a p-doped first semiconductor material, disposed on the second layer; a fourth layer comprising a n-doped first semiconductor material, and disposed on the third layer; and a fifth layer comprising a p-doped second semiconductor material that is disposed on the fourth layer; a sixth layer comprising a n-doped second semiconductor material that is disposed on the fifth layer; a seventh layer comprising a p-doped third semiconductor material that is disposed on the sixth layer; an eighth layer comprising a n-doped third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising a buried PN junction disposed in between the fourth layer and the third layer.
Example 7. The micro-PV cell of example 6, wherein the first semiconductor material comprises GaAs; the second semiconductor material comprises GaAs; the third semiconductor material comprises InGaP.
Example 8. The micro-PV cell of example 6 or 7, wherein the first layer comprises Semi-Insulated GaAs; the second layer comprises n-GaAs; the third layer comprises p-GaAs; the fourth layer comprises n-GaAs; the fifth layer comprises p-GaAs; the sixth layer comprises n-GaAs the seventh layer comprises p-InGaP; and the eighth layer comprises n-InGaP.
Example 9. The micro-PV cell of any of examples 6, 7, or 8, wherein the first layer comprises Semi-Insulated GaAs; the second layer comprises p-GaAs; the third layer comprises p-GaAs; the fourth layer comprises n-GaAs; the fifth layer comprises p-GaAs; the sixth layer comprises n-GaAs; the seventh layer comprises p-InGaP; and the eighth layer comprises n-InGaP.
Example 10. A photovoltaic (PV) device comprising a string of at least three, micro-PV cells with an identical layer structure connected in series, comprising: a first micro-PV cell disposed on a common substrate; a second micro-PV cell disposed on the common substrate and electrically connected in series to the first micro-PV cell; and a third micro-PV cell disposed on the common substrate and electrically connected in series to the second micro-PV cell; wherein each one of the first, second, and third micro-PV cells comprises: a left-side and a right-side; a first layer comprising a p-doped first semiconductor material; a second layer comprising a n-doped first semiconductor material, disposed on the first layer; a multi-junction micro-PV cell stack disposed on a portion of the second layer; a first trench extending down into the first layer, disposed on a left-side of the micro-PV cell; a second trench extending down into the first layer, and disposed on the right-side of the micro-PV cell; a third trench, disposed adjacent to the second trench and extending down into the second layer, wherein the third trench is disposed on the right-side of the micro-PV cell adjacent to a left-side of the second trench; a left-side first shoulder disposed on the left-side of the micro-PV cell at a bottom of the first trench; a right-side second shoulder disposed on the right-side of the micro-PV cell at a bottom of the third trench; an integrated monolithic bypass diode comprising a buried PN junction disposed in between the second layer and the first layer; wherein the first micro-PV cell comprises a first top surface; wherein the second micro-PV cell comprises a second top surface; wherein the third micro-PV cell comprises a third top surface; and a first conductor electrically connecting the first layer to the first top surface of the first micro-PV cell; a second conductor electrically connecting the right-side second shoulder of the first micro-PV cell to the second top surface of the second micro-PV cell; and a third conductor electrically connecting the right-side second shoulder of the second micro-PV cell to the third top surface of the third micro-PV cell; wherein the common substrate is the first layer.
Example 11. The PV device of example 10, wherein the PV device is configured to attach to a photovoltaic micro-solar panel of an extraterrestrial satellite.
Example 12. The PV device of example 10 or 11, wherein the multi-junction micro-PV cell stack of each micro-PV cell comprises: a third layer comprising a p-doped second semiconductor material that is disposed on the second layer; a fourth layer comprising a n-doped second semiconductor material that is disposed on the third layer; a fifth layer comprising a p-doped third semiconductor material that is disposed on the fourth layer; and a sixth layer comprising a n-doped third semiconductor material that is disposed on the fifth layer.
Example 13. The PV device of example 12, wherein the first layer comprises p-Ge; and the second layer of each micro-PV cell comprises n-Ge.
Example 14. The PV device of example 12 or 13, wherein: the second semiconductor material comprises GaAs; and the third semiconductor material comprises GaAs.
Example 15. The PV device of any of examples 12, 13, or 14, wherein: the first layer comprises p-Ge; the second layer of each micro-PV cell comprises n-Ge; the third layer of each micro-PV cell comprises p-GaAs; the fourth layer of each micro-PV cell comprises n-GaAs; the fifth layer of each micro-PV cell comprises p-InGaP; and the sixth layer of each micro-PV cell comprises n-InGaP.
Example 16. A photovoltaic (PV) device comprising a string of at least three, identical micro-PV cells connected in series, comprising: a first micro-PV cell disposed on a common substrate; a second micro-PV cell disposed on the common substrate and electrically connected in series to the first micro-PV cell; and a third micro-PV cell disposed on the common substrate and electrically connected in series to the second micro-PV cell; wherein each one of the first, second, and third micro-PV cells comprises: a left-side and a right-side; a first layer comprising a first semiconductor material; a second layer comprising the first semiconductor material that is disposed on the first layer; a third layer comprising the first semiconductor material that is disposed on the second layer; a fourth layer comprising the first semiconductor material that is disposed on the third layer; and a fifth layer comprising a second semiconductor material that is disposed on the fourth layer; a sixth layer comprising the second semiconductor material that is disposed on the fifth layer; a seventh layer comprising a third semiconductor material that is disposed on the sixth layer; an eighth layer comprising a third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into the second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising a buried PN junction disposed in between the fourth layer and the third layer; wherein the first micro-PV cell comprises a first top surface; wherein the second micro-PV cell comprises a second top surface; wherein the third micro-PV cell comprises a third top surface; a first conductor electrically connecting the first layer to the first top surface of the first micro-PV cell; a second conductor electrically connecting the right-side second shoulder of the first micro-PV cell to the second top surface of the second micro-PV cell; a third conductor electrically connecting the right-side second shoulder of the second micro-PV cell to the third top surface of the third micro-PV cell; a fourth conductor electrically connecting the right-side second shoulder of the first micro-PV cell to the first left-side shoulder of the second micro-PV cell; a fifth conductor electrically connecting the right-side second shoulder of the second micro-PV cell to the first left-side shoulder of the third micro-PV cell; wherein the integrated monolithic bypass diode of each micro-PV cell comprises a PN junction disposed in-between the fourth layer and the third layer of each micro-PV cell; and wherein the common substrate is the first layer.
Example 17. The PV device of example 16, wherein: the first layer comprises semi-insulated GaAs; the second layer of each micro-PV cell comprises n-GaAs; the third layer of each micro-PV cell comprises p-GaAs; the fourth layer of each micro-PV cell comprises n-GaAs; the fifth layer of each micro-PV cell comprises p-GaAs; the sixth layer of each micro-PV cell comprises n-GaAs; the seventh layer of each micro-PV cell comprises p-InGaP; and the eighth layer of each micro-PV cell comprises n-InGaP.
Example 18. A photovoltaic (PV) device, comprising an array of multiple micro-PV cells disposed on a common substrate and electrically connected in series; wherein each micro-PV cell comprises: a left-side and a right-side; a first layer comprising a p-doped first semiconductor material; a second layer comprising a n-doped first semiconductor material, disposed on the first layer; a multi-junction micro-PV cell stack disposed on a portion of the second layer; a first trench extending down into the first layer, disposed on a left-side of each micro-PV cell; a second trench extending down into the first layer, and disposed on the right-side of each micro-PV cell; a third trench, disposed adjacent to the second trench and extending down into the second layer, wherein the third trench is disposed on the right-side of each micro-PV cell adjacent to a left-side of the second trench; a left-side first shoulder disposed on the left-side of each micro-PV cell at a bottom of the first trench; a right-side second shoulder disposed on the right-side of each micro-PV cell at a bottom of the third trench; and an integrated monolithic bypass diode comprising a PN junction disposed in-between the second layer and the first layer; wherein the common substrate is the first layer.
Example 19. The PV device of example 18, wherein the PV device comprises greater than or equal to forty-five micro-PV cells all connected in series, and the PV device has an output voltage that is greater than about 90 V.
Example 20. The PV device of example 18 or 19, wherein a surface area of an individual micro-PV cell in the PV device is less than or equal to about 1 cm².
Example 21. The PV device of any of examples 18, 19, or 20, further comprising a pair of electrical voltage tabs disposed at opposite corners of the PV device.
Example 22. The PV device of any of examples 18, 19, 20, or 21, wherein photocurrent generated by the array of multiple micro-PV cell, when illuminated, flows in a serial serpentine fashion across the PV device.
Example 23. The PV device of any of examples 18, 19, 20, 21, or 22, wherein the PV device has an octagonal shape.
Example 24. The PV device of any of examples 18, 19, 20, 21, 22, or 23, wherein the PV device has a surface area greater than or equal to about 45 cm².
Example 25. The PV device of any of examples 18, 19, 20, 21, 22, 23, or 24, wherein the common substrate comprises p-Ge.
Example 26. A photovoltaic (PV) device, comprising an array of multiple micro-PV cells disposed on a common substrate and electrically connected in series; wherein each micro-PV cell comprises: a left-side and a right-side; a first layer comprising a first semiconductor material; a second layer comprising the first semiconductor material, disposed on the first layer; a third layer comprising the first semiconductor material, disposed on the second layer; a fourth layer comprising the first semiconductor material, and disposed on the third layer; a fifth layer comprising a second semiconductor material that is disposed on the fourth layer; a sixth layer comprising the second semiconductor material that is disposed on the fifth layer; a seventh layer comprising a third semiconductor material that is disposed on the sixth layer; an eighth layer comprising a third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising a buried PN junction disposed in between the fourth layer and the third layer; wherein the common substrate is the first layer.
Example 27. The PV device of example 26, wherein the common substrate comprises semi-insulated GaAs.
Example 28. A photovoltaic (PV) solar panel, comprising an array of multiple PV devices, wherein each PV device comprises an array of multiple micro-PV cells disposed on a common substrate and electrically connected in series; wherein each micro-PV cell comprises: a right-side and a left-side; a first layer comprising a p-doped first semiconductor material; a second layer comprising a n-doped first semiconductor material, disposed on the first layer; a multi-junction micro-PV cell stack disposed on a portion of the second layer; a first trench extending down into the first layer, disposed on a left-side of the micro-PV cell; a second trench extending down into the first layer, and disposed on the right-side of the micro-PV cell; a third trench, disposed adjacent to the second trench and extending down into the second layer, wherein the third trench is disposed on the right-side of the micro-PV cell adjacent to a left-side of the second trench; a left-side first shoulder disposed on the left-side of the micro-PV cell at a bottom of the first trench; a right-side second shoulder disposed on the right-side of the micro-PV cell at a bottom of the third trench; and an integrated monolithic bypass diode comprising the second layer disposed on the first layer; wherein the common substrate is the first layer.
Example 29. The PV solar panel of example 28, further comprising: a positive polarity electrical bus comprising an interdigitated pattern of positive voltage conductors; and a negative polarity electrical bus comprising an interdigitated pattern of negative polarity voltage conductors; wherein the positive polarity electrical bus and the negative polarity electrical bus are electrically connected to the array of multiple PV devices.
Example 30. The PV solar panel of example 28 or 29, comprising one or more rows of PV devices, wherein each row comprises a plurality of PV devices electrically connected in parallel.
Example 31. The PV solar panel of example 30, wherein each PV device comprises a negative voltage tab and a positive voltage tab disposed on opposite sides of the PV device; and wherein a first positive voltage tab of a first PV device that is disposed on a first row of the PV solar panel is located directly across from a second positive voltage tab of an adjacent second PV device that is disposed on an adjacent second row of the PV solar panel.
Example 32. The PV solar panel of example 31, wherein each PV device comprises a negative voltage tab and a positive voltage tab disposed on opposite sides of the PV device; and wherein a first negative voltage tab of a first PV device that is disposed on a first row of the PV solar panel is located directly across from a second negative voltage tab of an adjacent second PV device that is disposed on an adjacent second row of the PV solar panel.
Example 33. The PV solar panel of any of examples 30, 31, or 32, further comprising a discrete blocking diode disposed between a PV solar device and the positive polarity electrical bus.
Example 34. A photovoltaic (PV) solar panel, comprising an array of multiple PV devices, wherein each PV device comprises an array of multiple micro-PV cells disposed on a common substrate and electrically connected in series; wherein each micro-PV cell comprises: a left-side and a right-side; a first layer comprising a first semiconductor material; a second layer comprising the first semiconductor material, disposed on the first layer; a third layer comprising the first semiconductor material, disposed on the second layer; a fourth layer comprising the first semiconductor material, and disposed on the third layer; a fifth layer comprising a second semiconductor material that is disposed on the fourth layer; a sixth layer comprising the second semiconductor material that is disposed on the fifth layer; a seventh layer comprising a third semiconductor material that is disposed on the sixth layer; an eighth layer comprising a third semiconductor material that is disposed on the seventh layer; a first trench extending down into the first layer and disposed on the left-side of the micro-PV cell; a second trench extending down into the first layer and disposed on the right-side of the micro-PV cell; a third trench, extending down into second layer and disposed on the left-side of the micro-PV cell adjacent to the first trench; a fourth trench extending down into the fourth layer and disposed on the right-side of the micro-PV cell adjacent to the second trench; a left-side first shoulder disposed on the left-side of the micro-PV cell at a bottom of the second trench; a right-side second shoulder disposed on the right-side of the micro-PV cell at a bottom of the fourth trench; and an integrated monolithic bypass diode comprising the fourth layer disposed on the third layer; wherein the common substrate is the first layer.

In the current disclosure, reference is made to various aspects. However, it should be understood that the present disclosure is not limited to specific described aspects. Instead, any combination of the features and elements, whether related to different aspects or not, is contemplated to implement and practice the teachings provided herein. Additionally, when elements of the aspects are described in the form of "at least one of A and B," it will be understood that aspects including element A exclusively, including element B exclusively, and including element A and B are each contemplated. Furthermore, although some aspects can achieve advantages over other possible solutions and/or over the prior art, whether or not a particular advantage is achieved by a given aspect is not limiting of the present disclosure. Thus, the aspects, features, aspects and advantages disclosed herein are merely illustrative and are not considered elements or limitations of the appended claims except where explicitly recited in a claim(s). Likewise, reference to "the invention" shall not be construed as a generalization of any inventive subject matter disclosed herein and shall not be considered to be an element or limitation of the appended claims except where explicitly recited in a claim(s).

Unless otherwise indicated, the terms "first," "second," etc. are used herein merely as labels, and are not intended to impose ordinal, positional, or hierarchical requirements on the items to which these terms refer. Moreover, reference to, for example, a "second" item does not require or preclude the existence of, for example, a "first" or lower-numbered item or a "third" or higher-numbered item.

Spatially relative terms, such as "beneath," "below," "lower," "above," "upper," and the like may be used herein for ease of description to describe the relationship of one component and/or feature to another component and/or feature, or other component(s) and/or feature(s), as illustrated in the drawings. It will be understood that the spatially relative terms are intended to encompass different orientations of the device in use or operation in addition to the orientation(s) depicted in the figures.

The terms "comprising", "comprise" and "comprises" herein are intended to be optionally substitutable with the terms "consisting essentially of", "consist essentially of", "consists essentially of", "consisting of", "consist of" and "consists of", respectively, in every instance. To the extent that terms "includes," "including," "has," "contains," and variants thereof are used herein, such terms are intended to be inclusive in a manner similar to the term "comprises" as an open transition word without precluding any additional or other elements.

## Claims

1. A photovoltaic (PV) micro-PV cell (100), comprising:
a first layer (12) comprising a p-doped first semiconductor material;
a second layer (14), comprising a n-doped first semiconductor material, disposed on the first layer (12);
a multi-junction micro-PV cell stack (16) disposed on a portion of the second layer (14);
a first trench (22) extending down into the first layer (12), disposed on a left-side of the micro-PV cell (100);
a second trench (22') extending down into the first layer (12), and disposed on a right-side of the micro-PV cell (100);
a third trench (52), disposed adjacent to the second trench (22') and extending down into the second layer (14), wherein the third trench (52) is disposed on the right-side of the micro-PV cell (100) adjacent to a left-side of the second trench (22');
a left-side first shoulder (26) disposed on the left-side of the micro-PV cell (100) at a bottom of the first trench (22);
a right-side second shoulder (24) disposed on the right-side of the micro-PV cell (100) at a bottom of the third trench (52); and
an integrated monolithic bypass diode comprising a buried PN junction (15) disposed in between the second layer (14) and the first layer (12).

2. The micro-PV cell (100) of claim 1, wherein the multi-junction micro-PV cell stack (16) comprises one or two or three PN junctions (15, 17, 19).

3. The micro-PV cell (100) of claim 1 or 2, wherein no metal is disposed on a backside of the p-doped first layer (12).

4. The micro-PV cell (100) of any of claims 1 to 3, further comprising:
a third layer (42) comprising a p-doped second semiconductor material, disposed on the second layer (14);
a fourth layer (44) comprising a n-doped second semiconductor material, disposed on the third layer (42);
a fifth layer (46) comprising a p-doped third semiconductor material, disposed on the fourth layer (44); and
a sixth layer (48) comprising a n-doped third semiconductor material, disposed on the fifth layer (46).

5. The micro-PV cell (100) of claim 4, wherein:
the first layer (12) comprises p-Ge;
the second layer (14) comprises n-Ge;
the third layer (42) comprises p-GaAs;
the fourth layer (44) comprises n-GaAs;
the fifth layer (46) comprises p-InGaP; and
the sixth layer (48) comprises n-InGaP.

6. The micro-PV cell (100) of claim 4, wherein:
the first layer (12) comprises p-Ge;
the second layer (14) comprises n-GaAs on p-GaAs;
the third layer (42) comprises p-GaAs;
the fourth layer (44) comprises n-GaAs;
the fifth layer (46) comprises p-InGaP; and
the sixth layer (48) comprises n-InGaP.

7. A photovoltaic (PV) device (64), comprising an array of multiple micro-PV cells (100, 102, 104) disposed on a common substrate (600) and electrically connected in series;
wherein each micro-PV cell (100, 102, 104) comprises:
a first layer (12) comprising a p-doped first semiconductor material;
a second layer (14) comprising a n-doped first semiconductor material, disposed on the first layer (12);
a multi-junction micro-PV cell stack (16) disposed on a portion of the second layer (14);
a first trench (22) extending down into the first layer (12), disposed on a left-side of each micro-PV cell (100);
a second trench (22') extending down into the first layer (12), and disposed on a right-side of each micro-PV cell (100, 102, 104);
a third trench, disposed adjacent to the second trench (22') and extending down into the second layer (14), wherein the third trench is disposed on the right-side of each micro-PV cell (100, 102, 104) adjacent to a left-side of the second trench (22');
a left-side first shoulder (26) disposed on the left-side of each micro-PV cell (100, 102, 104) at a bottom of the first trench (22);
a right-side second shoulder (24) disposed on the right-side of each micro-PV cell (100, 102, 104) at a bottom of the third trench (22'); and
an integrated monolithic bypass diode comprising a PN junction disposed in-between the second layer (14) and the first layer (12);
wherein the common substrate (600) is the first layer (12).

8. The PV device (64) of claim 7, wherein the PV device (64) comprises greater than or equal to forty-five micro-PV cells (100, 102, 104) all connected in series, and the PV device (64) has an output voltage that is greater than about 90 V.

9. The PV device (64) of claim 7 or 8, further comprising a pair of electrical voltage tabs (90, 90') disposed at opposite corners of the PV device (64).

10. The PV device (64) of any of claims 7 to 9, wherein photocurrent generated by the array of multiple micro-PV cells (100, 102, 104), when illuminated, flows in a serial serpentine fashion across the PV device (64).

11. The PV device (64) of any of claims 7 to 10, wherein the common substrate (600) comprises p-Ge.

12. A photovoltaic (PV) solar panel (58), comprising an array of multiple PV devices (64), wherein each PV device (64) comprises an array of multiple micro-PV cells (100, 102, 104) disposed on a common substrate (600) and electrically connected in series;
wherein each micro-PV cell (100, 102, 104) comprises:
a first layer (12) comprising a p-doped first semiconductor material;
a second layer (14) comprising a n-doped first semiconductor material, disposed on the first layer (12);
a multi-junction micro-PV cell stack (16) disposed on a portion of the second layer (14);
a first trench (22) extending down into the first layer (12), disposed on a left-side of the micro-PV cell (100);
a second trench (22') extending down into the first layer (12), and disposed on a right-side of the micro-PV cell (100);
a third trench (52), disposed adjacent to the second trench (22') and extending down into the second layer (14), wherein the third trench (52) is disposed on the right-side of the micro-PV cell (100) adjacent to a left-side of the second trench (22');
a left-side first shoulder (26) disposed on the left-side of the micro-PV cell (100) at a bottom of the first trench (22);
a right-side second shoulder (26') disposed on the right-side of the micro-PV cell (100) at a bottom of the third trench (52); and
an integrated monolithic bypass diode (15) comprising the second layer (14) disposed on the first layer (12);
wherein the common substrate (600) is the first layer (12).

13. The PV solar panel (58) of claim 12, further comprising:
a positive voltage electrical bus comprising an interdigitated pattern of positive conductors; and
a negative voltage electrical bus comprising an interdigitated pattern of negative polarity conductors;
wherein the positive electrical voltage bus and the negative voltage electrical bus are electrically connected to the array of multiple PV devices, and
the PV solar panel (58) preferably further comprising a discrete blocking diode disposed between a PV solar device and the positive polarity electrical bus.

14. The PV solar panel (58) of claim 12 or 13, comprising one or more rows of PV devices (64, 64') , wherein each row comprises a plurality of PV devices (64, 64') electrically connected in parallel.

15. The PV solar panel (58) of claim 14,
wherein each PV device (64) comprises a negative voltage tab (90) and a positive voltage tab (90') disposed on opposite sides of the PV device (64); and
wherein a first positive voltage tab (90') of a first PV device (64) that is disposed on a first row (A) of the PV solar panel (58) is located directly across from a second positive voltage tab (92') of an adjacent second PV device (66') that is disposed on an adjacent second row (B) of the PV solar panel,
wherein each PV device (64) preferably comprises a negative voltage tab (90) and a positive output tab (90') disposed on opposite sides of the PV device (64); and
wherein preferably a first negative voltage tab (93) of a first PV device (64) that is disposed on a first row (A) of the PV solar panel (58) is located directly across from a second negative voltage tab (94) of an adjacent second PV device (66') that is disposed on an adjacent second row (B) of the PV solar panel (58).
